# EUROPÄISCHE PATENTSCHRIFT

(11) **EP 2 047 526 B1**
(45) Veröffentlichungstag und Bekanntmachung des Hinweises auf die Patenterteilung: **25.07.2018**
(21) Anmeldenummer: 07817414.1
(22) Anmeldetag: 27.07.2007
(51) Int. Cl.: H01L 33/58, H01L 33/60, H01L 33/44

(54) **BELEUCHTUNGSANORDNUNG**
LIGHTING ASSEMBLY
ENSEMBLE D'ÉCLAIRAGE

(30) Priorität: 31.07.2006 DE 102006035635
(43) Veröffentlichungstag der Anmeldung: 15.04.2009
(73) Patentinhaber: OSRAM Opto Semiconductors GmbH, 93055 Regensburg (DE)
(72) Erfinder: WANNINGER, Mario, 93055 Harting/Regensburg (DE); ZEILER, Markus, 93152 Nittendorf (DE); OTT, Hubert, 93077 Bad Abbach (DE)
(74) Vertreter: Epping - Hermann - Fischer
(86) Internationale Anmeldenummer: PCT/DE2007/001348
(87) Internationale Veröffentlichungsnummer: WO 2008/014771

(56) Entgegenhaltungen:
- EP-A- 1 227 458
- EP-A- 1 653 254
- WO-A2-03/049204
- DE-A1- 19 738 972
- JP-A- 1 258 481
- JP-A- 2006 013 265
- US-A1- 2004 037 076
- US-A1- 2005 243 577
- US-A1- 2006 082 297
- US-A1- 2006 138 440
- ZEILER M ET AL: "44.5L: Late-News Paper: Optimization Parameters for LED Backlighting Solutions" SID 2006, 2006 SID INTERNATIONAL SYMPOSIUM, SOCIETY FOR INFORMATION DISPLAY, LO, Bd. XXXVII, Juni 2006 (2006-06), Seiten 1524-1527, XP007012779 ISSN: 0006-966X

## Beschreibung

Die Erfindung betrifft eine Beleuchtungsanordnung mit einem optoelektronischen Bauteil als Strahlungsquelle. Die Druckschrift WO 03/049204 A2 (OSRAM OPTO SEMICONDUCTORS GMBH [DE]; ARNDT KARLHEINZ [DE]; FARCHTCHIAN; 12. Juni 2003) beschreibt eine Beleuchtungsanordnung gemäß dem Oberbegriff des Anspruchs 1.

Bei Beleuchtungsanordnungen wie LEDs, die zur Hinterleuchtung von Anzeigevorrichtungen vorgesehen sind, stellt sich oft das Problem, dass die Ausleuchtung der Anzeigevorrichtung nicht ausreichend homogen erfolgt. So können beispielsweise besonders stark ausgeleuchtete Teilbereiche bei der Betrachtung der Anzeigevorrichtung störend wirken.
Eine Aufgabe der vorliegenden Erfindung ist es, eine Beleuchtungsanordnung anzugeben, deren abgestrahlte Strahlung vereinfacht zuverlässig gemäß einer vorgegebenen Abstrahlcharakteristik geformt ist oder geformt werden kann.
Diese Aufgabe wird erfindungsgemäß durch eine Beleuchtungsanordnung nach einem der unabhängigen Patentansprüche gelöst. Vorteilhafte Ausgestaltungen und Weiterbildungen der Erfindung sind Gegenstand der abhängigen Patentansprüche.
In einer ersten Ausführungsform umfasst eine erfindungsgemäße Beleuchtungsanordnung eine optische Vorrichtung mit einer Strahlungsaustrittsfläche und ein optoelektronisches Bauteil zur Erzeugung von Strahlung, wobei ein reflektorartig geformtes Element gebildet ist, dessen Formgebung und Anordnung des reflektorartig geformten Elements dafür geeignet ist, im Bauteil erzeugte Strahlung durch die Strahlungsaustrittsfläche umzulenken, und wobei das Element für im Bauteil erzeugte Strahlung gezielt absorbierend ausgebildet ist.
Im Betrieb der Beleuchtungsanordnung tritt durch die Strahlungsaustrittsfläche vorwiegend Strahlung aus, welche im optoelektronischen Bauteil erzeugt wird und ohne eine vorhergehende Reflexion in der Beleuchtungsanordnung, insbesondere an dem reflektorartig geformten Element, auf die optische Vorrichtung trifft. Strahlung, die nach einer Reflexion an dem reflektorartig geformten Element durch die Strahlungsaustrittsfläche austreten würde, wird dagegen vorwiegend absorbiert, da das reflektorartig geformte Element für im optoelektronischen Bauteil erzeugte Strahlung gezielt absorbierend ausgebildet ist. Mit Vorteil kann so der Strahlungsanteil vermindert werden, welcher nach einer oder mehreren Reflexionen in der Beleuchtungsanordnung und damit unter einem nur schwer kontrollierbaren Winkel aus der Strahlungsaustrittsfläche austritt. Die Formung der insgesamt aus der Strahlungsaustrittsfläche austretenden Strahlung gemäß einer vorgegebenen Abstrahlcharakteristik kann so vereinfacht erzielt werden.
Bevorzugt ist die optische Vorrichtung als vom optoelektronischen Bauteil separate Komponente ausgeführt. Gemäß der vorliegenden Erfindung enthält das optoelektronische Bauteil mindestens einen zur, Strahlungserzeugung geeigneten Halbleiterchip. Der Halbleiterchip weist eine Oberfläche, die der optischen Vorrichtung zugewandt ist, und eine Seitenfläche auf. Im Halbleiterchip erzeugte Strahlung kann durch diese Flächen austreten.
Bevorzugt ist das reflektorartig geformte Element so ausgebildet und relativ zum Halbleiterchip angeordnet, dass Strahlung, welche aus der Seitenfläche des Halbleiterchips austritt, vorwiegend auf das reflektorartig geformte Element trifft und von diesem gezielt absorbiert wird. Damit wird vermieden, dass aus dem Halbleiterchip ausgekoppelte Strahlung nicht unmittelbar, sondern erst nach einer oder mehrerer Reflexionen innerhalb der Beleuchtungsanordnung auf die Strahlungsaustrittsfläche trifft. Der optischen Vorrichtung wird so hauptsächlich durch die Oberfläche des Halbleiterchips austretende Strahlung zur Verfügung gestellt. Diese aus der Oberfläche ausgetretene Strahlung erfährt vor Auftreffen auf die Strahlungsaustrittsfläche keine Reflexion und kann durch die optische Vorrichtung vereinfacht gemäß einer vorgegebenen Abstrahlcharakteristik geformt werden.

Die insgesamt aus der Strahlungsaustrittsfläche der optischen Vorrichtung austretende Strahlungsleistung verringert sich um den Anteil der vom optoelektronischen Bauteil erzeugten Strahlungsleistung, welcher von dem gezielt absorbierend ausgebildeten reflektorartig geformten Element absorbiert wird. Dies betrifft insbesondere die aus der Seitenfläche des Halbleiterchips austretende Strahlung. Dieser ' Strahlungsanteil könnte aber, wenn er nicht absorbiert, sondern auf die optische Vorrichtung gelenkt würde, von dieser nur schwer gemäß der vorgegebenen Abstrahlungscharakteristik geformt werden. Dies gilt im Besonderen, wenn die optische Vorrichtung für die Strahlformung der aus der in der Regel kleinflächigen Oberfläche austretenden Strahlung ausgebildet und geeignet angeordnet ist. Für eine derartige optische Vorrichtung stellt unter Reflexion auftreffende Strahlung einen unerwünschten Streustrahlungsanteil dar. Dieser Streustrahlungsanteil kann durch die gezielt absorbierende Ausführung des reflektorartig geformten Elements vermindert werden. Die aus der Beleuchtungsanordnung austretende Strahlung, welche bevorzugt.im sichtbaren Spektralbereich liegt, kann in der Folge vereinfacht gemäß einer der Beleuchtungsanordnung vorgegebenen, insbesondere gerichteten, Abstrahlcharakteristik geformt sein.

Gemäß der vorliegenden Erfindung ist der Halbleiterchip als Dünnfilm-Halbleiterchip ausgebildet, wobei die der optischen Vorrichtung zugewandte Oberfläche des Halbleiterchips als eine Hauptstrahlungsauskoppelfläche ausgeführt ist und die Seitenfläche eine Nebenstrahlungsaustrittsfläche bildet. Die aus der Hauptstrahlungsauskoppelfläche austretende Strahlungsleistung ist dabei größer als die aus der Nebenstrahlungsaustrittsfläche austretende Strahlungsleistung. Bevorzugt ist die Summe der aus den Nebenstrahlungsaustrittsflächen austretenden Strahlungsleistung kleiner als die durch die Hauptstrahlungsauskoppelfläche austretende Strahlungsleistung.
In einer weiteren Ausführungsform umfasst eine erfindungsgemäße Beleuchtungsanordnung ein optoelektronisches Bauteil mit mindestens einem zur Strahlungserzeugung vorgesehenen Halbleiterchip, der als Dünnfilm-Halbleiterchip ausgeführt ist und eine als Hauptstrahlungsauskoppelfläche ausgeführte Oberfläche und eine eine Nebenstrahlungsaustrittsfläche bildende Seitenfläche aufweist, wobei ein reflektorartig geformtes Element gebildet ist, dessen Formgebung und Anordnung dafür geeignet ist, zumindest einen Teil der aus der Nebenstrahlungsaustrittsfläche austretenden Strahlung umzulenken, und wobei das Element für von dem Halbleiterchip emittierte Strahlung gezielt absorbierend ausgebildet ist.
Eine derartig ausgeführte Beleuchtungsanordnung stellt vom Dünnfilm-Halbleiterchip erzeugte Strahlung zur Verfügung, welche vorwiegend aus der Hauptstrahlungsauskoppelfläche austritt. Aus den Seitenflächen austretende Strahlung wird dagegen von dem gezielt absorbierend ausgebildeten reflektorartig geformten Element vorwiegend absorbiert.

Damit wird die auf eine nachfolgende separate Optik auftreffende Strahlung aus einer, genau definierten Fläche, der Hauptstrahlungsauskoppelfläche des Dünnfilm-Halbleiterchips, abgestrahlt und kann vereinfacht gemäß einer vorgegebenen Abstrahlcharakteristik geformt werden.

In einer bevorzugten Ausgestaltung umfasst die Beleuchtungsanordnung eine optische Vorrichtung mit einer Strahlungsaustrittsfläche, durch die vom Dünnfilm-Halbleiterchip erzeugte Strahlung aus der Beleuchtungsanordnung austreten kann.

Ein Dünnfilm-Halbleiterchip umfasst einen Träger und einen Halbleiterkörper mit einer Halbleiterschichtenfolge, wobei der Halbleiterkörper auf dem Träger angeordnet ist. Im Gegensatz zu einem herkömmlichen Halbleiterchip ist bei einem Dünnfilm-Halbleiterchip der Träger von einem Aufwachssubstrat, auf dem die Halbleiterschichtenfolge, beispielsweise mittels Epitaxie, abgeschieden ist, verschieden. Das Aufwachssubstrat kann bereichsweise oder vollständig entfernt oder gedünnt sein. Dies kann beispielsweise mechanisch oder chemisch erfolgen. Der Träger dient der mechanischen Stabilisierung des Halbleiterkörpers. Das Aufwachssubstrat ist hierfür nicht mehr erforderlich.

Mit Vorteil muss der Träger im Gegensatz zu dem Aufwachssubstrat nicht die hohen Anforderungen hinsichtlich der kristallinen Reinheit erfüllen, sondern kann vielmehr im Hinblick auf andere Kriterien, wie beispielsweise mechanische Stabilität, optische, thermische oder elektrische Eigenschaften ausgewählt werden.

In einer bevorzugten Ausgestaltung ist auf dem Halbleiterkörper eine Spiegelschicht angeordnet. Bevorzugt ist die Spiegelschicht zwischen dem Träger und dem Halbleiterkörper angeordnet. Die Spiegelschicht enthält weiterhin bevorzugt ein Metall oder eine metallische Legierung oder ist metallisch ausgeführt. Beispielsweise kann die Spiegelschicht Au, Al, Ag, Pd, Rh oder Pt oder eine Legierung mit mindestens einem dieser Materialien enthalten. Au zum Beispiel zeichnet sich durch eine hohe Reflektivität im roten und infraroten Spektralbereich aus, während Ag oder Al auch im blauen oder ultravioletten Spektralbereich eine hohe Reflektivität zeigt.

Im aktiven Bereich erzeugte und in Richtung des Trägers verlaufende Strahlung kann an der Spiegelschicht reflektiert und an einer dem Träger abgewandten, die Hauptstrahlungsauskoppelfläche bildenden, Oberfläche des Halbleiterchips emittiert werden, wodurch sich vorteilhaft der durch die Hauptstrahlungsauskoppelfläche ausgekoppelte Strahlungsanteil erhöht. Weiterhin kann die Spiegelschicht einer Absorption von Strahlung durch das Trägermaterial vorbeugen, was die Freiheitsgrade bei der Auswahl des Trägermaterials weitergehend erhöht.

In Dünnfilm-Halbleiterchips verringert sich die aus den seitlichen Nebenstrahlungsaustrittsflächen austretende Strahlungsleistung zugunsten einer gesteigerten aus der Hauptstrahlungsauskoppelfläche ausgekoppelten Strahlungsleistung. Da von der Beleuchtungsanordnung bevorzugt im Wesentlichen nur die aus der Oberfläche des Halbleiterchips austretende Strahlung zur Verfügung gestellt wird, während aus der Seitenfläche austretende Strahlung von dem gezielt absorbierend ausgebildeten reflektorartig geformten Element überwiegend absorbiert wird, erhöht sich mit einem Dünnfilm-Halbleiterchip als Strahlungsquelle vorteilhaft die von der Beleuchtungsanordnung abgestrahlte Strahlungsleistung. Deshalb sind Dünnfilm-Halbleiterchips als Strahlungsquelle besonders geeignet.

Als reflektorartig geformtes Element kann ein Element in der Beleuchtungsanordnung oder ein im optoelektronischen Bauteil integriertes Element angesehen werden, dessen Formgebung und Anordnung relativ zum optoelektronischen Bauteil, insbesondere gegebenenfalls zu dessen Halbleiterchip, und/oder zur optischen Vorrichtung geeignet ist, um Strahlung, die vom optoelektronischen Bauteil emittiert wird und auf das Element trifft, zumindest teilweise direkt oder indirekt durch die Strahlungsaustrittsfläche umzulenken. Die Form des reflektorartig geformten Elements ist in weiten Grenzen frei wählbar, solange aufgrund dessen Formgebung und Anordnung zumindest ein Teil der im optoelektronischen Bauteil erzeugten Strahlung von diesem Element, durch die Strahlungsaustrittsfläche gelenkt werden könnte und insbesondere vermehrt gelenkt würde, falls auf eine gezielt absorbierende Ausbildung verzichtet würde. Beispielsweise kann das reflektorartig geformte Element die Form einer ebenen oder einer gekrümmten Fläche aufweisen.

Das reflektorartig geformte Element wird im Zusammenhang mit der vorliegenden Erfindung als gezielt absorbierend angesehen, wenn die Reflektivität des reflektorartig geformten Elements für im optoelektronischen Bauteil erzeugte Strahlung 15% oder weniger, bevorzugt 5% oder weniger beträgt. Ein möglichst niedriger Werte für die Reflektivität des reflektorartig geformten Elements ist vorteilhaft, da so der Anteil von Strahlung reduziert wird, welcher an dem reflektorartig geformten Element reflektiert wird. Vielmehr wird die Strahlung in entsprechendem Maße absorbiert. Typischerweise ist das absorbierend ausgebildete reflektorartig geformte Element so ausgeführt, dass vom optoelektronischen Bauteil erzeugte Strahlung nicht durch dieses Element transmittiert wird. Der Absorptionsgrad A des gezielt absorbierend ausgebildeten reflektorartig geformten Elements und die Reflektivität R, welche auch als Reflexionsgrad bezeichnet wird, sind damit über die Beziehung A=1-R miteinander verknüpft.
Ein offensichtlich als Reflektor ausgebildetes Element mit einer nicht oder nur mit großem Aufwand vermeidbaren Restabsorption ist nicht als im obigen Sinne gezielt absorbierend ausgebildet anzusehen. Dies bezieht sich sowohl auf gerichtet reflektierende Elemente wie in der Regel metallische Elemente oder Elemente mit einer Metalloberfläche als auch auf diffus reflektierende Elemente wie zum Beispiel weiße Kunststoff-Formteile, die typischerweise bei einem Gehäusekörper für optoelektronische Bauteile wie beispielsweise Leuchtdioden eingesetzt werden.

In einer bevorzugten Ausgestaltung ist das reflektorartig geformte Element vollständig oder zumindest teilweise aus einem die im optoelektronischen Bauteil erzeugte Strahlung absorbierenden Material oder einer absorbierenden Materialzusammensetzung gefertigt oder vollständig oder teilweise mit einem die im optoelektronischen Bauteil erzeugte Strahlung absorbierenden Material oder einer absorbierenden Materialzusammensetzung versehen, beispielsweise beschichtet, etwa bedruckt oder bestempelt.

In einer besonders bevorzugten Ausgestaltung ist das reflektorartig geformte Element vollständig oder teilweise aus schwarzem, dunkelgrauem oder geschwärztem Material oder einer schwarzen, dunkelgrauen oder geschwärzten Materialzusammensetzung gefertigt. Alternativ oder ergänzend kann das reflektorartig geformte Element mit schwarzem oder dunkelgrauem Material oder einer schwarzen oder dunkelgrauen Materialzusammensetzung versehen, beispielsweise beschichtet, sein. Insbesondere kann das Element vollständig oder teilweise aus Kunststoff gefertigt sein, wobei dieser Kunststoff beispielsweise durch Farbstoffe, rußartige oder rußähnliche Partikel geschwärzt ist. Im sichtbaren Spektralbereich wird ein Material oder eine Materialzusammensetzung als schwarz aufgefasst, wenn das Material gleichmäßig über diesen Spektralbereich hinreichend stark absorbierend ausgebildet ist, um als schwarz wahrgenommen zu werden. Unter einem geschwärzten Material wird insbesondere ein Material verstanden, das als grau oder dunkelgrau wahrgenommen wird.

Gemäß einer weiteren bevorzugten Ausgestaltung weist das optoelektronische Bauteil einen Gehäusekörper auf, der bevorzugt das reflektorartig geformte Element enthält. Zudem weist das optoelektronische Bauelement bevorzugt einen externen Anschlussleiter auf, auf dem der Halbleiterchip befestigt und insbesondere elektrisch kontaktiert ist. Typischerweise ist der Halbleiterchip mit einem zweiten externen Anschlussleiter elektrisch leitend verbunden.

Insbesondere können die elektrischen Anschlussteile mit dem Gehäusekörper umformt sein. Das optoelektronische Bauteil kann in der so genannten Premolded-Gehäuseform ausgeführt sein, bei welcher der Gehäusekörper vorgefertigt ist. Der Halbleiterchip kann in dieser Ausgestaltung auf einem bereits vom Gehäusekörper umformten elektrischen Anschlussleiter montiert werden. Die externen Anschlussleiter, welche mittels eines Leiterrahmens gebildet sein können, ermöglichen eine externe elektrische Kontaktierung des Halbleiterchips und können mit Leiterbahnen eines Anschlussträgers, beispielsweise einer Leiterplatte, elektrisch leitend verbunden werden. Bevorzugt erfolgt die elektrische Verbindung mittels Lötens, insbesondere bleifreien Lötens.

In einer bevorzugten Ausgestaltung weist das optoelektronische Bauteil ein thermisches Anschlussteil auf, das der thermischen Kontaktierung des optoelektronischen Bauteils dient. Dieses thermische Anschlussteil ist vorzugsweise zusätzlich zu dem elektrischen Anschlussleiter ausgebildet. Mit Vorteil kann durch eine thermisch leitende Verbindung dieses thermischen Anschlussteils mit einer externen Wärmesenke die im Betrieb des optoelektronischen Bauteils erzeugte Wärme weitgehend unabhängig von den elektrischen Anschlüssen abgeleitet werden.

In einer weiteren bevorzugten Ausgestaltung wird das reflektorartig geformte Element mittels einer Wand einer Kavität des Gehäusekörpers gebildet. Besonders bevorzugt ist der Halbleiterchip in der Kavität angeordnet. Durch eine derartige Anordnung kann der Halbleiterchip vereinfacht vor externen mechanischen Einflüssen geschützt werden. Zudem kann durch die absorbierende Ausführung des reflektorartig geformten Elements ein Großteil der Strahlung, welche aus dem Halbleiterchip ausgekoppelt wird und nur in Folge einer Reflexion auf die Strahlungsaustrittsfläche treffen würde, vorwiegend absorbiert werden. Einfach- und Mehrfachreflexionen von Strahlung innerhalb der Beleuchtungsanordnung und ein nachfolgender Austritt dieser Streustrahlung aus der Beleuchtungsanordnung unter einem nur schwer kontrollierbaren Winkel werden hierdurch mit Vorteil vermindert.

In einer weiteren bevorzugten Ausgestaltung enthält der Gehäusekörper eine Keramik oder einen Kunststoff oder ist teilweise oder vollständig aus einer Keramik oder einem Kunststoff gefertigt. Keramik zeichnet sich üblicherweise durch eine gute Wärmeleitfähigkeit aus, so dass die im Betrieb des optoelektronischen Bauteils erzeugte Wärme effizient abgeführt werden kann. Gehäusekörper auf der Basis von Kunststoffen lassen sich besonders kostengünstig fertigen.

In einer weiteren bevorzugten Ausgestaltung ist der Gehäusekörper, insbesondere das reflektorartig geformte Element, vollständig oder teilweise aus einem Material gefertigt, das die im optoelektronischen Bauteil erzeugte Strahlung gezielt absorbiert. Alternativ oder ergänzend kann der Gehäusekörper, insbesondere die das reflektorartig geformte Element bildende Wand der Kavität des Gehäusekörpers, vollständig oder teilweise schwarz, geschwärzt oder geeignet beschichtet sein. Beispielsweise können rußartige oder rußähnliche Partikel oder Farbstoffe eingesetzt werden, um Kunststoff schwarz oder dunkelgrau zu färben.

In einer weiteren bevorzugten Ausgestaltung ist der Halbleiterchip in eine, insbesondere für die im Halbleiterchip erzeugte Strahlung durchlässige, Umhüllung eingebettet. Diese Umhüllung kann den Halbleiterchip, insbesondere vollständig, abdecken. Auch eine elektrische Kontaktierung des Halbleiterchips, beispielsweise ein Bonddraht, kann von der Umhüllung abgedeckt sein. Die Umhüllung ist vorzugsweise ausreichend formfest ausgebildet, um den Chip und gegebenenfalls den Bonddraht vor schädlichen äußeren Einflüssen, wie etwa mechanischer Belastung, schützen zu können. Beispielsweise kann die Umhüllung ein Reaktionsharz, ein Silikonharz oder ein Silikon enthalten.

In einer weiteren bevorzugten Ausgestaltung ist zwischen der Umhüllung und der optischen Vorrichtung eine Zwischenschicht ausgebildet, welche besonders bevorzugt an die optische Vorrichtung und an die Umhüllung unmittelbar, angrenzt. Vorzugsweise dient die Zwischenschicht als Brechungsindexanpassungsschicht zwischen der Umhüllung und der optischen Vorrichtung.

In einer bevorzugten Ausgestaltung weist die optische Vorrichtung eine optische Achse auf, welche bevorzugt durch den Halbleiterchip, insbesondere im Wesentlichen durch das Zentrum des Halbleiterchips, etwa den Schwerpunkt einer lateral verlaufenden Querschnittsfläche des Halbleiterchips, verläuft.

In einer weiteren bevorzugten Ausgestaltung weist die optische Vorrichtung eine Strahlungseintrittsfläche auf, welche dem optoelektronischen Bauteil zugewandt ist. Zweckmäßigerweise ist die Strahlungseintrittsfläche der der Auskopplung von Strahlung dienenden Oberfläche des Halbleiterchips zugewandt. Der minimale Abstand zwischen dem Halbleiterchip und der Strahlungsseintrittsfläche beträgt bevorzugt 3 mm oder weniger, besonders bevorzugt 1 mm oder weniger, beispielsweise 0,6 mm.

Bevorzugt beträgt der minimale Abstand zwischen der Strahlungsaustrittsfläche der optischen Vorrichtung und der Oberfläche des Halbleiterchips 5 mm oder weniger, bevorzugt 3 mm oder weniger, beispielsweise 2 mm. Die Verminderung der Streustrahlung ermöglicht eine zuverlässige Strahlformung durch die optische Vorrichtung bei sehr geringen Abständen der optischen Vorrichtung zum Halbleiterchip. Die Beleuchtungsanordnung kann somit besonders kompakt gefertigt sein.

In einer bevorzugten Ausgestaltung ist die Strahlungsaustrittsfläche rotationssymmetrisch zur optischen Achse ausgeführt. Dadurch kann eine Abstrahlcharakteristik erreicht werden; welche im Wesentlichen rotationssymmetrisch zur optischen Achse ist. Teile der optischen Vorrichtung, die hauptsächlich nicht der Strahlformung dienen, sondern beispielsweise zur Montage der optischen Vorrichtung an dem optoelektronischen Bauteil vorgesehen sind, können von der Rotationssymmetrie zur optischen Achse abweichend ausgebildet sein.

In einer bevorzugten Ausgestaltung weist die Strahlungsaustrittsfläche der optischen Vorrichtung einen konkav gekrümmten Teilbereich und einen den konkav gekrümmten Teilbereich zumindest teilweise umgebenden, konvex gekrümmten Teilbereich auf. Die optische Achse verläuft mit Vorzug durch den konkav gekrümmten Teilbereich und besonders bevorzugt gleichzeitig durch den Halbleiterchip, insbesondere im Wesentlichen durch dessen Zentrum, etwa den Schwerpunkt einer lateral verlaufenden Querschnittsfläche des Halbleiterchips. Strahlung, die im optoelektronischen Bauteil erzeugt wird und nicht deckungsgleich mit der optischen Achse direkt auf den konkav gekrümmten Teilbereich trifft, wird vorwiegend von der optischen Achse weg gebrochen.

So verringert sich der Anteil der Strahlung, welche sich im Wesentlichen in Richtung der optischen Achse, etwa unter einem Winkel von 20° oder weniger zur optischen Achse, ausbreitet. Dagegen erhöht sich der Strahlungsanteil, der die Beleuchtungsanordnung in großen Winkeln zur optischen Achse, beispielsweise 30° oder mehr, verlässt. Die von der Beleuchtungsanordnung abgestrahlte Strahlungsleistung als Funktion des Winkels zur optischen Achse zeigt vorzugsweise ein Maximum bei vergleichsweise großen Winkeln von 30° oder mehr, zum Beispiel bei einem Winkel zwischen einschließlich 60° und einschließlich 70°.

Eine Beleuchtungsanordnung mit einer solchen Abstrahlcharakteristik eignet sich besonders für die Ausleuchtung einer sich im Wesentlichen senkrecht zur optischen Achse der Beleuchtungsanordnung erstreckenden Fläche und insbesondere zur Hinterleuchtung von Anzeigevorrichtungen, etwa LCDs (liquid crystal display). Typischerweise ist die auszuleuchtende Fläche erheblich größer als die Fläche des Halbleiterchips. Eine Abstrahlcharakteristik mit einem Maximum der abgestrahlten Strahlungsleistung bei einem großen Winkel zur optischen Achse, bevorzugt bei einem Winkel von 60° oder mehr, ist von Vorteil, da so Bereiche der auszuleuchtenden Fläche in vergleichsweise großem Abstand zur optischen Achse auch bei geringen Abständen der Fläche von der Beleuchtungsanordnung beleuchtet werden können. So kann etwa die Hinterleuchtungseinheit eines LCDs vorteilhaft besonders kompakt mit einer geringen Bautiefe gefertigt sein.

Bevorzugt weist der konvex gekrümmte Teilbereich einen ersten Unterbereich und einen zweiten Unterbereich auf, wobei die Krümmung des ersten Unterbereichs kleiner als die Krümmung des zweiten Unterbereichs ist. Dabei kann der zweite Unterbereich in einem größeren Abstand zur optischen Achse angeordnet sein als der erste Unterbereich. Vorzugsweise nimmt die Krümmung des konvex gekrümmten Teilbereichs, insbesondere die Krümmung des zweiten Unterbereichs, mit wachsendem Abstand vom konkav gekrümmten Teilbereich zu. Eine mit dem Abstand kontinuierlich zunehmende Krümmung ist bevorzugt, aber nicht zwingend. Eine Zunahme der Krümmung kann bewirken, dass der Anteil von Strahlung, die unter einem großen Winkel zur optischen Achse austritt, vorteilhaft erhöht ist. Eine gleichmäßige Ausleuchtung von Teilflächen der zu beleuchtenden Fläche, die sich in vergleichsweise großem Abstand zur optischen Achse befinden, wird so gefördert.

Strahlung, die aus der Oberfläche des Halbleiterchips austritt und direkt auf die Strahlungsaustrittsfläche trifft, wird von dieser besonders effizient in große Winkel von 30° und mehr zur optischen Achse gebrochen. Streustrahlung würde dagegen überwiegend in Richtung der optischen Achse gelenkt werden und in der Folge zu einer stärkeren Ausleuchtung der zu beleuchtenden Fläche im Bereich um deren Schnittpunkt mit der optischen Achse führen. Durch die gezielt absorbierende Ausbildung des reflektorartig geformten Elements kann dieser Streustrahlungsanteil vermindert werden. Eine auszuleuchtende Fläche kann so streustrahlungsarm, großflächig und besonders homogen ausgeleuchtet werden. Insbesondere kann das Ausbilden stärker ausgeleuchteter Bereiche, welche sich inselartig um den Schnittpunkt der Fläche mit der optischen Achse erstrecken, mit Vorteil vermindert werden.

Weiterhin kann auch Strahlung, die von außerhalb der Beleuchtungsanordnung auf die Strahlungsaustrittsfläche trifft und durch die optische Vorrichtung hindurch tritt, einen Streustrahlungsanteil verursachen, falls diese Strahlung im Bauteil reflektiert wird und durch die Strahlungsaustrittsfläche der optischen Vorrichtung wieder austritt. Dieser wieder austretende Anteil der Strahlung wird auch als Phantomlicht bezeichnet und kann beim Einsatz der Beleuchtungsanordnung zur Hinterleuchtung von Anzeigevorrichtungen, wie beispielsweise LCDs oder LCD-Fernsehern, das Kontrastverhältnis der Anzeigevorrichtung mindern. Mit der gezielt absorbierenden Ausführung des reflektorartig geformten Elements und insbesondere des gesamten Gehäusekörpers kann der Phantomlichteinfluss weitgehend unterdrückt werden, was zu einer vorteilhaften Steigerung des Kontrastverhältnisses der Anzeigevorrichtung führen kann.

In einer bevorzugten Ausgestaltung ist die optische Vorrichtung an dem optoelektronischen Bauteil befestigt. Dazu kann die optische Vorrichtung beispielsweise als Aufsatzoptik, insbesondere als Überstülpoptik, als Aufsteckoptik oder als Aufschnappoptik ausgeführt sein. Alternativ oder zusätzlich kann die optische Vorrichtung an das optoelektronische Bauteil geklebt werden.

Hierbei ist unter einer Aufsteckoptik eine optische Vorrichtung zu verstehen, welche ein Befestigungselement aufweist, das in eine geeignete Montagevorrichtung des optoelektronischen Bauteils, z.B. eine Ausnehmung des Gehäusekörpers, eingesteckt werden kann. Ergänzend können die Befestigungselemente nach der Montage der optischen Vorrichtung an dem optoelektronischen Bauteil heißverstemmt werden, so dass die optische Vorrichtung besonders stabil und dauerhaft an dem optoelektronischen Bauteil befestigt ist.

Bei einer Aufschnappoptik weist die optische Vorrichtung ein Befestigungselement auf, welches in einer geeigneten Montagevorrichtung des optoelektronischen Bauteils einrastet.

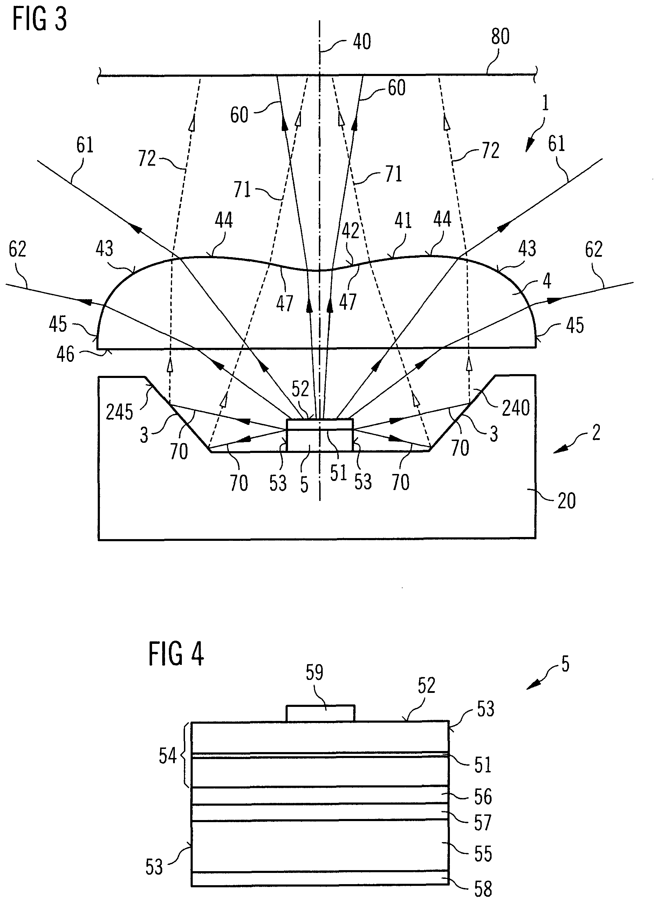

Eine Überstülpoptik kann eingriffsfrei und/oder rastverbindungsfrei am optoelektronischen Bauteil befestigt werden. Spezielle Elemente zur Befestigung am optoelektronischen Bauteil sind bei einer Überstülpoptik nicht erforderlich. Ergänzend kann die Überstülpoptik an das optoelektronische Bauteil geklebt werden.
Bevorzugt ist die Beleuchtungsanordnung und insbesondere das optoelektronische Bauteil im Wesentlichen frei von Diffusoren und/oder Lumineszenzkonvertern ausgeführt, da sowohl Streuung von im optoelektronischen Bauteil erzeugter Strahlung an Diffusoren als auch die Absorption der Strahlung mit nachfolgender Re-Emission durch Lumineszenzkonverter dazu führen würde, dass die Abstrahlung des optoelektronischen Bauteils vermehrt ungerichtet erfolgen würde. Zudem ist die Umhüllung und gegebenenfalls die Zwischenschicht vorzugsweise klar ausgeführt. Dadurch kann die von dem optoelektronischen Bauteil zur Verfügung gestellte Strahlung durch die optische Vorrichtung vereinfacht gemäß einer vorgegebenen Abstrahlcharakteristik geformt werden. Gemäß der vorliegenden Erfindung ist das optoelektronische Bauteil als oberflächenmontierbares Bauteil (surface mountable device, SMD) ausgeführt.
Besonders bevorzugt ist die Beleuchtungsanordnung mit dem optoelektronischen Bauteil und an dem optoelektronischen Bauteil befestigten optischen Vorrichtung als Verbundbauteil ausgebildet. Als Verbundbauteil kann die Beleuchtungsanordnung als Ganzes vereinfacht, beispielsweise auf eine Leiterplatte, montiert werden. Vorzugsweise ist das Verbundbauteil als oberflächenmontierbares Bauteil ausgeführt.
Weitere Merkmale, vorteilhafte Ausgestaltungen und Zweckmäßigkeiten der Erfindung ergeben sich aus der folgenden Beschreibung der Ausführungsbeispiele in Verbindung mit den Figuren.
Es zeigen:
Figur 1 eine schematische Schnittansicht eines ersten Ausführungsbeispiels einer erfindungsgemäßen Beleuchtungsanordnung,
Figur 2 eine schematische Schnittansicht eines zweiten Ausführungsbeispiels einer erfindungsgemäßen Beleuchtungsanordnung,
Figur 3 ein Beispiel für eine schematische Darstellung des Strahlenverlaufs bei einer erfindungsgemäßen Beleuchtungsanordnung,
Figur 4 eine schematische Schnittansicht eines für eine erfindungsgemäße Beleuchtungsanordnung besonders geeigneten Halbleiterchips,
Figur 5A eine schematische perspektivische Ansicht einer erfindungsgemäßen Beleuchtungsanordnung,
Figur 5B eine schematische Schnittansicht durch eine Beleuchtungsanordnung gemäß Figur 5A in perspektivischer Darstellung.
Figur 6A ein Beispiel für die Abstrahlcharakteristik (relative Intensität I als Funktion des Winkels ϑ zur optischen Achse) einer Beleuchtungsanordnung mit einem nicht gezielt absorbierend ausgebildeten reflektorartig geformten Element,
Figur 6B ein Beispiel für die Abstrahlcharakteristik (relative Intensität I als Funktion des Winkels ϑ zur optischen Achse) einer erfindungsgemäßen Beleuchtungsanordnung mit einem gezielt absorbierend ausgebildeten reflektorartig geformten Element,
Figur 7A ein Beispiel für die relative Beleuchtungsstärke B als Funktion der Entfernung d zur optischen Achse für eine Beleuchtungsanordnung mit einem nicht gezielt absorbierend ausgebildeten reflektorartig geformten Element und
Figur 7B ein Beispiel für die relative Beleuchtungsstärke B als Funktion der Entfernung d zur optischen Achse für eine erfindungsgemäße Beleuchtungsanordnung mit einem gezielt absorbierend ausgebildeten reflektorartig geformten Element.
Gleiche, gleichartige und gleich wirkende Elemente sind in den Figuren mit gleichen Bezugszeichen versehen.

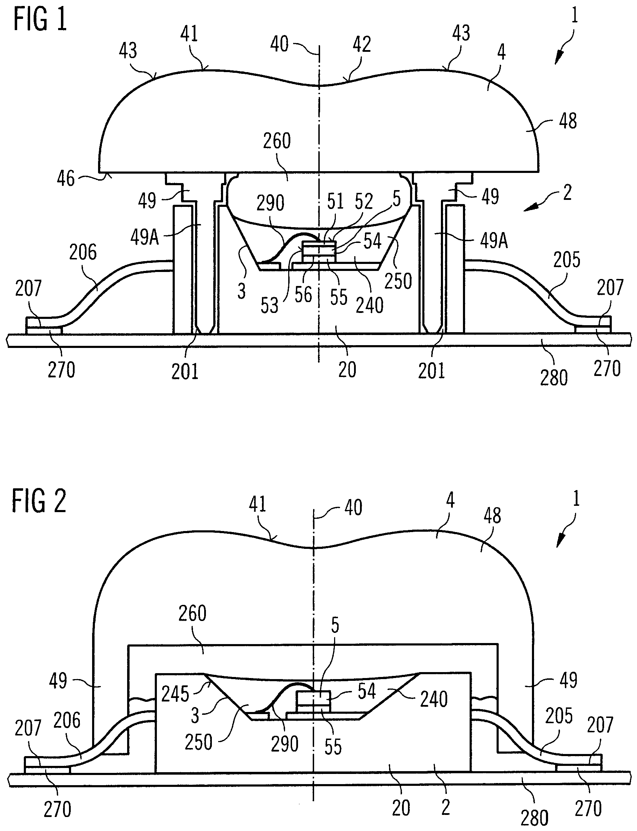

In den Figuren 1 und 2 sind zwei Ausführungsbeispiele einer erfindungsgemäßen. Beleuchtungsanordnung 1 gezeigt. Die Beleuchtungsanordnung umfasst jeweils eine optische Vorrichtung 4, ein optoelektronisches Bauteil 2 und ein gezielt absorbierend ausgebildetes reflektorartig geformtes Element 3. Von dem optoelektronischen Bauteil 2 erzeugte Strahlung tritt durch eine Strahlungsaustrittsfläche 41 der optischen Vorrichtung aus der Beleuchtungsanordnung aus.
Weiterhin enthält das optoelektronische Bauteil einen zur Strahlungserzeugung vorgesehenen Halbleiterchip 5, der als Dünnfilm-Halbleiterchip ausgeführt ist. Ein typischer Aufbau eines Dünnfilm-Halbleiterchips ist im Zusammenhang mit Figur 4 näher beschrieben.
Das optoelektronische Bauteil 2 umfasst das reflektorartig geformte Element 3. Das optoelektronische Bauteil 2 enthält zudem einen Gehäusekörper 20. Das reflektorartig geformte Element 3 wird durch eine Wand 245 einer Kavität 240 des Gehäusekörpers gebildet. Der Halbleiterchip 5 ist in der Kavität 240 des Gehäusekörpers 20 angeordnet.
Der Gehäusekörper 20 kann eine Keramik enthalten oder vollständig oder teilweise aus einer Keramik hergestellt sein. Keramik zeichnet sich typischerweise durch eine hohe thermische Leitfähigkeit aus, so dass im Betrieb des optoelektronischen Bauteils erzeugte Wärme effizient über den Gehäusekörper abgeführt werden kann. Alternativ kann der Gehäusekörper aus Kunststoff, beispielsweise in einem Spritzguss-, Spritzpressguss- oder Pressgussverfahren, gefertigt sein. Gehäusekörper aus Kunststoff sind besonders kostengünstig herstellbar. Zudem können die gleichen Gussformen eingesetzt werden wie bei der Herstellung von Leuchtdioden, bei denen die Gehäusekörper möglichst stark reflektierend ausgeführt sind, um die von der Leuchtdiode abgestrahlte Strahlungsleistung zu maximieren. Auf kostenintensive, neu herzustellende Gussformen kann vorteilhaft verzichtet werden.

Das reflektorartig geformte Element 3 ist für die im optoelektronischen Bauteil erzeugte Strahlung gezielt absorbierend ausgebildet. Dazu kann das reflektorartig geformte Element 3 und weitergehend der Gehäusekörper 20 vollständig oder teilweise aus einem die im optoelektronischen Bauteil erzeugte Strahlung absorbierenden Material oder einer absorbierenden Materialzusammensetzung gefertigt sein. Bevorzugt ist das reflektorartig geformte Element und insbesondere der Gehäusekörper schwarz oder dunkelgrau ausgeführt. Beispielsweise kann ein Gehäusekörper aus Kunststoff durch Zugabe von Farbstoffen, rußartigen oder rußähnlichen Partikeln in die verwendete Kunststoffmasse schwarz oder dunkelgrau ausgebildet sein.

Alternativ oder ergänzend kann das reflektorartig geformte Element 3 und insbesondere der Gehäusekörper 20 mit einem die im optoelektronischen Bauteil erzeugte Strahlung absorbierenden Material oder einer absorbierenden Materialzusammensetzung versehen, beispielsweise beschichtet, z.B. bedruckt oder bestempelt, sein.

Insbesondere beträgt die verbleibende Reflektivität des gezielt absorbierend ausgebildeten reflektorartig geformten Elements 3 im Wellenlängenbereich der vom optoelektronischen Bauteil emittierten Strahlung 15% oder weniger, bevorzugt 5% oder weniger.
Weiterhin ist der Halbleiterchip 5 auf einem ersten elektrischen Anschlussleiter 205 befestigt, der bevorzugt eine elektrisch leitende Verbindung zu einem externen Anschluss, z.B. einer Leiterbahn, ermöglicht. Ein zweiter elektrischer Anschlussleiter 206 kann beispielsweise über einen Bonddraht 290 mit der dem elektrischen Anschlussleiter abgewandten Oberseite 52 des Halbleiterchips elektrisch verbunden sein. Die Enden 207 des ersten 205 und zweiten 206 Anschlussleiters können mittels eines Lots 270, insbesondere eines bleifreien Lots, auf einer Leiterplatte 280 befestigt sein.
Der erste elektrischen Anschlussleiter 205 und der zweite elektrische Anschlussleiter 206 sind von dem Gehäusekörper 20 umformt und ragen aus verschiedenen Seiten des Gehäusekörpers heraus. Bevorzugt sind der erste und der zweite elektrische Anschlussleiter durch einen Leiterrahmen für das optoelektronische Bauteil 2 gebildet.
Weiterhin ist das optoelektronische Bauteil 2 als oberflächenmontierbares Bauteil ausgeführt. Die Beleuchtungsanordnung 1 kann mit dem optoelektronischen Bauteil 2 und der optischen Vorrichtung 4 als ein Verbundbauteil ausgeführt sein.
Gegenüber einer Einzelmontage des optoelektronischen Bauteils und der optischen Vorrichtung kann eine als oberflächenmontierbares Verbundbauteil ausgeführte Beleuchtungsanordnung vereinfacht auf der Leiterplatte 280 montiert werden.
Die Kavität 240 des Gehäusekörpers enthält eine Umhüllungsmasse 250, in welche der Halbleiterchip 5 und der Bonddraht eingebettet sind. Eine vollständige Einbettung ist hierbei von Vorteil. Diese Umhüllung dient zum Schutz des Halbleiterchips 5 und des Bonddrahts vor schädlichen äußeren Einflüssen und mechanischen Belastungen. Zweckmäßigerweise ist die Umhüllungsmasse strahlungsdurchlässig für vom Halbleiterchip erzeugte Strahlung ausgeführt.

Weiterhin ist eine Zwischenschicht 260 zwischen der Umhüllungsmasse 250 und einer Strahlungseintrittsfläche 46 der optischen Vorrichtung 4 eingebracht, welche besonders bevorzugt an die Umhüllungsmasse und an die Strahlungseintrittsfläche unmittelbar angrenzt. Diese Zwischenschicht kann zur Brechungsindexanpassung zwischen der Umhüllung und der optischen Vorrichtung ausgebildet sein.

Bevorzugt sind das optoelektronische Bauteil, die Zwischenschicht und die Umhüllung im Wesentlichen frei von Diffusoren und/oder Lumineszenzkonvertern ausgeführt. Dadurch kann eine vermehrt ungerichtete Abstrahlung vermieden werden, so dass die von dem optoelektronischen Bauteil zur Verfügung gestellte Strahlung durch die optische Vorrichtung vereinfacht gemäß einer vorgegebenen Abstrahlcharakteristik geformt werden kann.

Eine optische Achse 40 der optischen Vorrichtung 4 verläuft durch den Halbleiterchip 5, insbesondere im Wesentlichen durch das Zentrum des Halbleiterchips. Bevorzugt ist die optische Achse senkrecht oder im Wesentlichen senkrecht zur Oberfläche 52 des Halbleiterchips 5. Die optische Vorrichtung weist ein Strahlformungsteil 48 und ein Trägerteil 49 auf. Das Trägerteil ist zur Befestigung der optischen Vorrichtung an dem optoelektronischen Bauteil vorgesehen;

Das Strahlformungsteil 48 und das Trägerteil 49 der optischen Vorrichtung 4 können aus unterschiedlichen Materialien gefertigt und insbesondere aneinander angeformt sein. Durch das aneinander Anformen des Strahlformungsteils und des Trägerteils wird eine haftvermittlungsfreie mechanisch stabile Verbindung des Trägerteils mit dem Strahlformungsteil erleichtert. Die Materialien für das Trägerteil und das Strahlformungsteil können im Hinblick auf unterschiedliche Anforderungen ausgewählt werden. Bei dem Strahlformungsteil sind optische Eigenschaften wie Transparenz und Strahlungsresistenz für von dem optoelektronischen Bauteil emittierte Strahlung besonders bedeutsam.

Bevorzugt enthält das Strahlformungsteil 48 ein Silikon oder ein Silikon-Hybridmaterial oder besteht aus einem derartigen Material. Das Trägerteil 49 ist dagegen nicht zur Strahlungsformung vorgesehen und kann deshalb auch strahlungsundurchlässig ausgebildet sein. Das Material für das Trägerteil kann hinsichtlich besonderer Anforderungen wie mechanische Stabilität oder gute Befestigungseigenschaften ausgewählt sein. Ein Thermoplast oder ein Duroplast ist für die Fertigung des Trägerteils besonders geeignet.

Der Abstand zwischen der Strahlungseintrittsfläche 46 der optischen Vorrichtung und der Oberfläche des Halbleiterchips 52 beträgt 5 mm oder weniger, vorzugsweise 3mm oder weniger, bevorzugt 1 mm oder weniger, besonders bevorzugt etwa 0,6 mm. Die Beleuchtungsanordnung kann damit vorteilhaft besonders kompakt gefertigt sein.

Während bei den in den Figuren 1 und 2 gezeigten Ausführungsbeispielen das Strahlformungsteil der optischen Vorrichtung gleichartig wie im Zusammenhang mit Figur 3 beschrieben ausgebildet ist, unterscheiden sich die beiden Ausführungsbeispiele durch die Ausführung des Trägerteils und die Art der Befestigung am optoelektronischen Bauteil.

In Figur 1 ist die optische Vorrichtung 4 als Aufsteckoptik ausgeführt. Hierbei kann das Trägerteil 49 ein stiftartiges Befestigungselement 49A aufweisen, welches in eine geeignete Montagevorrichtung des optoelektronischen Bauteils 2 eingesteckt werden kann. Vorzugsweise wird die Montagevorrichtung durch eine Ausnehmung oder eine Aussparung 201 im Gehäusekörper 20 gebildet. Ergänzend kann das Befestigungselement nach der Montage der optischen Vorrichtung an dem optoelektronischen Bauteil heißverstemmt werden, so dass die optische Vorrichtung stabil und dauerhaft am optoelektronischen Bauteil befestigt ist.

In Figur 2 ist die optische Vorrichtung als Überstülpoptik ausgeführt. Ein Trägerteil 49 umläuft den Gehäusekörper 20 lateral, insbesondere vollständig. Dabei kann das Trägerteil eine äußerste Seitenfläche des Gehäusekörpers umgreifen. Weiterhin kann das Trägerteil vom Gehäusekörper großflächig lateral beabstandet sein. Eine vollständige Beabstandung ist hierbei von Vorteil.

Die Zwischenschicht 260 füllt das Volumen zwischen der optischen Vorrichtung 4 und dem Gehäusekörper 20 zumindest teilweise aus. Das Volumen zwischen der Umhüllungsmasse 250 und der Strahlungseintrittsfläche 46 ist vorzugsweise vollständig mit der Zwischenschicht ausgefüllt. Weiterhin bevorzugt umgreift bei einer Überstülpoptik die Zwischenschicht den Gehäusekörper. Die Zwischenschicht kann ein Silikon, insbesondere ein Silikongel, oder ein Silikon-Hybridmaterial enthalten oder hieraus, bestehen. So kann die Zwischenschicht gleichzeitig die Funktion einer Brechungsindexanpassungsschicht erfüllen und der einfachen, stabilen und dauerhaften Befestigung der optischen Vorrichtung 4 am optoelektronischen Bauteil 2 dienen.

Die in Figur 1 und 2 gezeigten Ausführungsbeispiele einer Beleuchtungsanordnung sind bevorzugt zur homogenen Ausleuchtung einer im Wesentlichen senkrecht zur optischen Achse 40 verlaufenden Fläche 80 vorgesehen. Da die zu beleuchtende Fläche typischerweise erheblich größer als die Oberfläche des Halbleiterchips 5 ist, ist es für eine gleichmäßige Ausleuchtung förderlich, wenn ein möglichst großer Teil der im optoelektronischen Bauteil 2 erzeugten Strahlung die Strahlungsaustrittsfläche 41 unter einem großen Winkel zur optischen Achse verlässt. Bevorzugt ist das Maximum der abgestrahlten Strahlungsleistung als Funktion des Winkels zur optischen Achse bei einem Winkel von größer oder gleich 50°, besonders bevorzugt größer oder gleich 60°, beispielsweise etwa 70°. Eine mögliche Formgebung für das Strahlformungsteil 48 der optischen Vorrichtung 4 einer solchen Beleuchtungsanordnung 1 und die Funktionsweise der optischen Vorrichtung 4 wird anhand von Figur 3 erläutert. Der Aufbau der gezeigten Beleuchtungsanordnung entspricht dabei demjenigen aus den Figuren 1 und 2. Aus Gründen der Übersichtlichkeit sind jedoch einige Details der Beleuchtungsanordnung, die für das Prinzip der Strahlformung der von dem Halbleiterchip 5 in einem aktiven Bereich 51 erzeugten Strahlung durch die optische Vorrichtung 4 gemäß einer der Beleuchtungsanordnung vorgegebenen Abstrahlcharakteristik nicht entscheidend sind, nicht dargestellt.

Die Strahlungseintrittsfläche 46 ist im Wesentlichen eben ausgeführt. Die Strahlformung der im optoelektronischen Bauteil erzeugten Strahlung gemäß einer der Beleuchtungsanordnung vorgegebenen Beleuchtungsstärkeverteilung erfolgt bevorzugt vorwiegend an der Strahlungsaustrittsfläche, wodurch eine zuverlässige Strahlformung vereinfacht ermöglicht wird.

Die Strahlungsaustrittsfläche 41 der optischen Vorrichtung ist vorzugsweise rotationssymmetrisch zur optischen Achse 40 der optischen Vorrichtung 4 ausgebildet. Teile der optischen Vorrichtung, die nicht der Strahlformung dienen, etwa das in den Figuren 1 und 2 jeweils gezeigte Trägerteil 49, können dabei abweichend von der Rotationssymmetrie ausgebildet sein.

Weiterhin weist die Strahlungsaustrittsfläche 41 einen konkav gekrümmten Teilbereich 42 auf. Die optische Achse 40 der optischen Vorrichtung 4 verläuft durch den konkav gekrümmten Teilbereich.

Der konkav gekrümmte Teilbereich 42 ist von einem konvex gekrümmten Teilbereich 43, insbesondere vollständig, umgeben. Bevorzugt ist der Flächeninhalt des konvex gekrümmten Teilbereichs größer als der Flächeninhalt des konkav gekrümmten Teilbereichs. Weiterhin weist der konvex gekrümmte Teilbereich einen ersten konvex gekrümmten Unterbereich 44 und einen zweiten konvex gekrümmten Unterbereich 45 auf.

Die im aktiven Bereich 51 des Halbleiterchips 5 erzeugte Strahlung tritt durch eine Oberfläche 52 des Halbleiterchips und eine Seitenfläche 53 aus. Die Wirkung der optischen Vorrichtung 4 auf aus der Oberfläche austretende Strahlung ist beispielhaft anhand der Strahlen 60, 61 und 62 gezeigt.

Für Strahlung 60, die auf den konkav gekrümmten Teilbereich 42 der Strahlungsaustrittsfläche 41 trifft, wirkt die optische Vorrichtung wie eine Zerstreuungslinse. Deshalb wird Strahlung, die schräg zur optischen Achse 40 oder in einem von null verschiedenen Abstand parallel zur optischen Achse auf den konkav gekrümmten Bereich der Strahlungsaustrittsfläche trifft, von der optischen Achse weg gebrochen. Dadurch verringert sich vorteilhaft der Strahlungsanteil, welcher die zu beleuchtende Fläche 80 im Bereich nahe der optischen Achse trifft. Ebenso wird Strahlung 61 und 62, welche auf den ersten 44 bzw. zweiten 45 konvex gekrümmten Unterbereich trifft, von der optischen Achse weg gebrochen. Der zweite konvex gekrümmte Unterbereich 45 ist bevorzugt stärker gekrümmt als der erste konvex gekrümmte Unterbereich 44, da so auf den zweiten Unterbereich auftreffende Strahlung 62 besonders effizient in große Winkel zur optischen Achse gebrochen werden kann.

Bevorzugt ist die Strahlungsaustrittsfläche 41 ohne kantige Übergänge ausgeführt, d.h. die gesamte Strahlungsaustrittsfläche ist eine an jedem Punkt, insbesondere an einem Übergang 47 zwischen dem konkav gekrümmten Teilbereich 42 und dem konvex gekrümmten Teilbereich 43, differenzierbare Fläche. Durch kantige Übergänge verursachte hellere oder dunklere Bereiche wie beispielsweise Ringe höherer Intensität auf der auszuleuchtenden Fläche können so mit Vorteil vermieden werden. Zudem verlaufen die Strahlengänge in bzw. an der optischen Vorrichtung bevorzugt im Wesentlichen totalreflexionsfrei.

Weiterhin ist die optische Vorrichtung bevorzugt so ausgeführt, dass sich zwei beliebige Strahlen, die von dem Bereich des aktiven Bereichs 51 ausgehen, der von der optischen Achse durchdrungen wird, nach dem Austritt aus der Strahlungsaustrittsfläche 41 nicht überschneiden. Sich überschneidende Strahlen können den Effekt einer lokalen Bündelung von Strahlung haben, so dass sich auf der zu beleuchtenden Fläche 80 zur Beleuchtungsanordnung Inhomogenitäten in der Bestrahlungsstärke, etwa in Form von Ringen oder Kreisen höherer Intensität, ausbilden können. Für den Fall einer idealen Punktlichtquelle, die auf der optischen Achse angeordnet ist, kann so eine solche lokale Bündelung vollständig vermieden werden.

Insbesondere Strahlung, die vor dem Auftreffen auf die Strahlungsaustrittsfläche 41 der optischen Vorrichtung 4 eine Reflexion erfährt, kann, sich überkreuzende Strahlengänge verursachen. Dies ist durch die in Figur 3 eingetragenen Strahlen 70 veranschaulicht, welche durch die Seitenflächen 53 des Halbleiterchips 5 austreten.

Für die Strahlen 70 ist durch Pfeile mit gestrichelten Linien 71 und 72 angedeutet, wie die Strahlen nach einer Reflexion an dem reflektorartig geformten Element verlaufen würden, wenn das reflektorartig geformte Element 3 nicht wie im Zusammenhang mit Figur 1 beschrieben für im Halbleiterchip erzeugte Strahlung gezielt absorbierend ausgebildet wäre, sondern beispielsweise aufgrund einer metallischen Beschichtung eine gerichtete Reflexion auftreffender Strahlung bewirken würde. Beispielsweise würden sich die Strahlen 71 mit den Strahlen 60 und die Strahlen 72 mit den Strahlen 61 nach Austritt aus der Strahlungsaustrittsfläche 41 kreuzen. Dadurch könnten sich auf der zu beleuchtenden Fläche für bestimmte Abstände der Fläche 80 von der Strahlungsaustrittsfläche Bereiche erhöhter Ausleuchtung ausbilden. Durch die gezielt absorbierende Ausführung des reflektorartig geformten Elements wird ein Auftreffen von Strahlung auf die Strahlungsaustrittsfläche nach einer vorhergehenden Reflexion an dem reflektorartig geformten Element 3 vermindert. Somit trifft vorwiegend Strahlung auf die optische Vorrichtung, welche aus einem genau definierten Bereich, der Oberfläche 52 des Halbleiterchips 5, aus dem Halbleiterchip austritt. In diesem Sinne nähert sich die Strahlung, welche auf die optische Vorrichtung trifft, der von einer idealen Punktlichtquelle emittierten Strahlung an. Sich überkreuzende Strahlenverläufe können so weitgehend vermieden werden, was eine besonders homogene Ausleuchtung der zu beleuchtenden Fläche 80 ermöglicht.

Außerdem würden im Falle einer gerichteten Reflexion an dem reflektorartig geformten Element sowohl der Strahl 71, welcher auf den konkav gekrümmten Teilbereich 42 der Strahlungsaustrittsfläche 41 umgelenkt würde, als auch der Strahl 72, welcher auf den konvex gekrümmten Teilbereich 43 treffen würde, nicht von der optischen Achse weg gebrochen werden, sondern vorwiegend zu einer Ausleuchtung des Teilbereichs der auszuleuchtenden Fläche 80 nahe der optischen Achse führen. Dieser zentrale Bereich der Fläche wäre dadurch stärker ausgeleuchtet. Auch ein reflektorartig geformtes Element, das diffus reflektierend mit einem hohen Reflexionskoeffizienten ausgeführt ist, etwa ein reflektorartig geformtes Element, das durch eine weiße Kunststoffoberfläche gebildet ist, würde vermehrt einen. Streulichtanteil verursachen und folglich eine stärkere Ausleuchtung der zu beleuchtenden Fläche im Bereich nahe des Schnittpunkts mit der optischen Achse, etwa in einem Abstand von 10 mm oder weniger zur optischen Achse, bewirken. Aufgrund der gezielt absorbierenden Ausführung des reflektorartig geformten Elements kann eine besonders homogene Ausleuchtung einer zu beleuchtenden Fläche, etwa einer Anzeigevorrichtung wie einem LCD, erzielt werden.

Bei einer Beleuchtungsanordnung, die zur Hinterleuchtung einer Anzeigevorrichtung vorgesehen ist, ist der Gehäusekörper vorzugsweise vollständig für den gesamten sichtbaren Spektralbereich gezielt absorbierend ausgebildet. Eine inhomogene Ausleuchtung infolge von Phantomstrahlung kann so besonders stark vermindert werden.

Die weitgehende Reduktion des Streulichtanteils erleichtert generell die Strahlformung der im optoelektronischen Bauteil erzeugten Strahlung gemäß einer der Beleuchtungsanordnung vorgegebenen, insbesondere gerichteten, Abstrahlcharakteristik.

In Figur 4 ist ein Ausführungsbeispiel eines für das optoelektronische Bauteil besonders geeigneten Halbleiterchips 5 anhand einer schematischen Schnittansicht gezeigt.

Der Halbleiterchip 5 weist einen auf einem Träger 55 angeordneten Halbleiterkörper 54 auf. Der Halbleiterkörper umfasst eine Halbleiterschichtenfolge mit einem zur Strahlungserzeugung vorgesehenen aktiven Bereich 51. Die Halbleiterschichtenfolge bildet den Halbleiterkörper 54. Auf der dem Träger abgewandten Seite des Halbleiterkörpers ist ein erster Kontakt 58 angeordnet, über den der Halbleiterchip in Verbindung mit einem auf der dem Halbleiterkörper abgewandten Seite des Trägers angeordneten zweiten Kontakt 59 elektrisch anschließbar ist. Der erste Kontakt 58 ist insbesondere zur elektrisch leitenden Verbindung mit einem Bonddraht und der zweiten Kontakt 59 zur elektrisch leitenden Verbindung mit einem Anschlussleiter vorgesehen. Die Kontakte können beispielsweise jeweils ein Metall oder eine Legierung enthalten.

In einer bevorzugten Ausgestaltung enthält der Halbleiterkörper 54, insbesondere der aktive Bereich 51, mindestens ein III-V-Halbleitermaterial, etwa ein Material aus den Materialsystemen InₓGa_{y}Al_{1-x-y}P, InₓGa_{y}Al_{1-x-y}N oder InₓGa_{y}Al_{1-x-y}As, jeweils mit 0≤x≤1, 0≤y≤1 und x+y≤1, insbesondere mit x ≠ 0, y ≠ 0, x ≠ 1 und/oder y ≠ 1. Bevorzugt erfolgt die Herstellung der Halbleiterschichtenfolge in einem, insbesondere epitaktischen, Abscheideprozess, etwa mittels MBE oder MOVPE auf einem Aufwachssubstrat.

III-V-Halbleitermaterialien sind zur Strahlungserzeugung im ultravioletten (InₓGa_{y}Al_{1-x-y}N) über den sichtbaren (InₓGa_{y}Al_{1-x-y}N, insbesondere für blaue bis grüne Strahlung, oder InₓGa_{y}Al_{1-x-y}P, insbesondere für gelbe bis rote Strahlung) bis in den infraroten (InₓGa_{y}Al_{1-x-y}As) Spektralbereich besonders geeignet. Mit III-V-Halbleitermaterialien, insbesondere aus den genannten Materialsystemen, können weiterhin bei der Strahlungserzeugung vorteilhaft hohe interne Quanteneffizienzen erzielt werden.

In einer weiteren bevorzugten Ausgestaltung umfasst der aktive Bereich 51 eine Heterostruktur, insbesondere eine Doppelheterostruktur. Weiterhin kann die aktive Zone eine Einfach- oder eine Mehrfach-Quantentopfstruktur umfassen. Mittels derartiger Strukturen, insbesondere einer Mehrfach-Quantentopfstruktur oder einer Doppelheterostruktur, können besonders hohe interne Quanteneffizienzen erzielt werden.

Die Bezeichnung Quantentopfstruktur umfasst im Rahmen der Anmeldung jegliche Struktur, bei der Ladungsträger durch Einschluss ("confinement") eine Quantisierung ihrer Energiezustände erfahren oder erfahren können. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

In einer weiteren bevorzugten Ausgestaltung ist auf dem Halbleiterkörper eine Spiegelschicht 56 angeordnet. Besonders bevorzugt ist die Spiegelschicht zwischen dem Halbleiterkörper 54 und dem Träger 55 angeordnet. Die Spiegelschicht kann beispielsweise als metallhaltige, insbesondere im Wesentlichen metallische, Spiegelschicht ausgeführt sein. Im aktiven Bereich erzeugte Strahlung kann an der Spiegelschicht reflektiert werden, wodurch einer Absorption in den der Spiegelschicht vom aktiven Bereich aus gesehen nachgeordneten Strukturen, etwa dem Träger, vorgebeugt wird. Die Effizienz des Halbleiterchips 5 kann so erhöht werden. Beispielsweise enthält die Spiegelschicht Au, Al, Ag, Pd, Rh, Pt oder eine Legierung mit mindestens einem dieser-Materialien. Al, Pd, Rh und Ag weisen im ultravioletten und blauen Spektralbereich, Au auch im gelben, orangen und roten bis in den infraroten Spektralbereich besonders hohe Reflektivitäten auf. Weiterhin wird durch Reflexion an der Spiegelschicht der Anteil an der der Spiegelschicht 56 gegenüberliegenden Seite des Halbleiterkörpers austretenden Strahlung erhöht.

Zwischen dem Träger 55 und der Spiegelschicht 56 kann eine Verbindungsschicht 57 angeordnet sein, mittels derer der Halbleiterkörper seitens der Spiegelschicht auf dem Träger befestigt ist. Die Verbindungsschicht 307 kann beispielsweise als Lotschicht ausgeführt sein.

Der in Figur 4 gezeigte Halbleiterchip ist als Dünnfilm-Halbleiterchip ausgeführt. Im Gegensatz zu einem herkömmlichen Halbleiterchip ist bei einem Dünnfilm-Halbleiterchip der Träger von einem Aufwachssubstrat, auf dem die Halbleiterschichtenfolge des Halbleiterkörpers, beispielsweise mittels Epitaxie, abgeschieden wird, verschieden. Das Aufwachssubstrat kann mechanisch und/oder chemisch bereichsweise oder vollständig entfernt oder gedünnt sein. Der Träger dient der mechanischen Stabilisierung des Halbleiterkörpers.

Mit Vorteil muss der Träger im Gegensatz zu dem Aufwachssubstrat nicht die hohen Anforderungen hinsichtlich der kristallinen Reinheit erfüllen, sondern kann vielmehr im Hinblick auf andere Kriterien, wie beispielsweise mechanische Stabilität, thermische oder elektrische Eigenschaften ausgewählt werden.

Bevorzugt weist der Träger 55 eine vergleichsweise hohe Wärmeleitfähigkeit auf. Beispielsweise enthält der Träger Ge. Auch ein GaAs-haltiger Träger kann Anwendung, finden.

Der aktive Bereich 51 ist bevorzugt mit dem zweiten Kontakt 59 über den elektrisch leitfähigen Träger, die elektrisch leitfähige Verbindungsschicht und die elektrisch leitfähige Spiegelschicht sowie die Halbleiterschichtenfolge des Halbleiterkörpers elektrisch leitend verbunden.

Enthält der Träger ein Halbleitermaterial, so ist der Träger vorzugsweise zur Erhöhung der Leitfähigkeit geeignet dotiert.

Zur Herstellung eines Dünnfilm-Halbleiterchips wird beispielsweise zunächst die Halbleiterschichtenfolge des Halbleiterkörpers 54 auf dem Aufwachssubstrat hergestellt. Die Halbleiterschichtenfolge bildet den Halbleiterkörper 54. Nachfolgend wird auf die dem Aufwachssubstrat abgewandte Seite des vorgefertigten Halbleiterkörpers die Spiegelschicht 56, etwa mittels Aufdampfens oder Sputterns, aufgebracht. Seitens der Spiegelschicht wird der Verbund mit Halbleiterschichtenfolge und Aufwachssubstrat hierauf über die Verbindungsschicht 57 mit dem Träger 55 verbunden, woraufhin das Aufwachssubstrat, etwa mittels Ätzens oder Lasertrennens, entfernt oder abgelöst wird.
Ein Dünnfilm-Halbleiterchip, etwa ein Dünnfilm-Leuchtdioden-Chip, kann sich weiterhin im Rahmen der vorliegenden Erfindung durch folgende charakteristische Merkmale auszeichnen:
- an einer zu einem Trägerelement, z.B. dem Träger 55, hin gewandten ersten Hauptfläche eines Halbleiterkörpers, der eine Halbleiterschichtenfolge mit einem aktiven Bereich umfasst, insbesondere einer Epitaxieschichtenfolge, ist eine Spiegelschicht aufgebracht oder, etwa als Braggspiegel in der Halbleiterschichtenfolge integriert, ausgebildet, die zumindest einen Teil der in der Halbleiterschichtenfolge erzeugten Strahlung in diese zurückreflektiert;
- die Halbleiterschichtenfolge weist eine Dicke im Bereich von 20*µ*m oder weniger, insbesondere im Bereich von 10 *µ*m auf; und/oder
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, d.h. sie weist ein möglichst ergodisch stochastisches Streuverhalten auf.
Ein Grundprinzip eines Dünnfilm-Leuchtdiodenchips ist beispielsweise in I. Schnitzer et al., Appl. Phys. Lett. 63 (16), 18. Oktober 1993, 2174 - 2176 beschrieben. Dünnfilm-Halbleiterchips zeichnen sich, insbesondere mit einer Spiegelschicht, durch eine vorteilhaft hohe Effizienz aus. Weiterhin kann ein Dünnfilm-Halbleiterchip eine im Wesentlichen einem Lambertschen Strahler entsprechende kosinusförmige Abstrahlcharakteristik aufweisen. Mittels eines Dünnfilm-Halbleiterchips, insbesondere mit metallhaltiger oder metallischer Spiegelschicht, kann vereinfacht ein als Oberflächenstrahler ausgeführter Halbleiterchip realisiert werden.

Die der Spiegelschicht abgewandte Oberfläche 52 des Halbleiterkörpers ist bei dem dargestellten Dünnfilmchip als eine Hauptstrahlungsauskoppelfläche ausgebildet. Eine Seitenfläche 53 bildet eine Nebenstrahlungsaustrittsfläche. Die aus der Hauptstrahlungsauskoppelfläche austretende Strahlungsleistung ist dabei größer als die aus der Nebenstrahlungsaustrittsfläche austretende Strahlungsleistung. Insbesondere ist die Summe der aus den Nebenstrahlungsaustrittsflächen austretenden Strahlungsleistung kleiner als die durch die Hauptstrahlungsauskoppelfläche austretende Strahlungsleistung.

In Dünnfilm-Halbleiterchips verringert sich die aus den seitlichen Nebenstrahlungsaustrittsflächen austretende Strahlungsleistung zugunsten einer gesteigerten aus der Hauptstrahlungsauskoppelfläche ausgekoppelten Strahlungsleistung. Da von der Beleuchtungsanordnung 1 bevorzugt im Wesentlichen nur die aus der Oberfläche 52 des Halbleiterchips austretende Strahlung zur Verfügung gestellt werden soll, während seitlich austretende Strahlung wie im Zusammenhang mit Figur 3 beschrieben von dem gezielt absorbierend ausgebildeten reflektorartig geformten Element 3 vorwiegend absorbiert wird, erhöht sich damit vorteilhaft die von der Beleuchtungsanordnung 1 abgestrahlte Strahlungsleistung. Deshalb sind Dünnfilm-Halbleiterchips als Strahlungsquelle besonders geeignet.

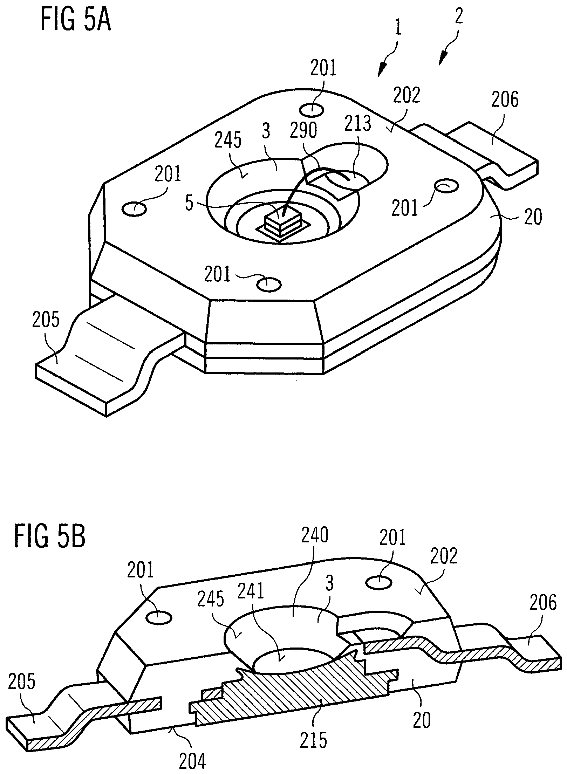

Es sei angemerkt, dass eine andere Beleuchtungsanordnung, die nicht gemäß der vorliegenden Erfindung ausgeführt ist, selbstverständlich nicht nur mit einem Dünnfilm-Halbleiterchip realisiert werden kann. Auch ein Halbleiterchip, bei dem das Aufwachssubstrat nicht abgelöst ist, kann für die Beleuchtungsanordnung geeignet sein. Ein solcher Halbleiterchip kann den in Figur 4 gezeigten Aufbau aufweisen. In diesem Fall wird der Träger 55 durch das Aufwachssubstrat gebildet. Die Verbindungsschicht 57 ist dann' nicht erforderlich. Auf die Spiegelschicht 56 kann verzichtet werden oder sie kann als Bragg-Spiegel, bestehend aus einer Folge von Schichten, beispielsweise als Teil der Halbleiterschichtenfolge des Halbleiterkörpers 54, ausgeführt sein.
Ein weiteres Ausführungsbeispiel einer Beleuchtungsanordnung ist in den Figuren 5A und 5B gezeigt, wobei Figur 5A eine perspektivische Ansicht und Figur 5B eine perspektivische Schnittansicht darstellt. Wie im Zusammenhang mit den Figuren 1 und 2 beschrieben weist die Beleuchtungsanordnung 1 ein optoelektronisches Bauteil 2 auf, bei dem ein reflektorartig geformtes Element durch eine Wand 245 einer Kavität 240 eines Gehäusekörpers 20 gebildet ist und für im optoelektronischen Bauteil erzeugte Strahlung gezielt absorbierend ausgebildet ist. Ein Dünnfilm-Halbleiterchip 5 dient als Strahlungsquelle.
Die Kavität 240 ist als Ausnehmung in einer ersten Hauptfläche 202 des Gehäusekörpers 20 gebildet. Ein Boden 241 der Kavität verläuft vorzugsweise im Wesentlichen parallel zur ersten Hauptfläche. Bevorzugt nimmt die Ausdehnung der Kavität in einer sich parallel zur ersten Hauptfläche erstreckenden Ebene mit zunehmendem Abstand von der ersten Hauptfläche, insbesondere kontinuierlich, ab, so dass der Boden der Kavität einen kleineren Durchmesser aufweist als der Durchmesser der Kavität in der Ebene der ersten Hauptfläche. Beispielsweise kann die Kavität im Wesentlichen die Form eines Kegelstumpfs, dessen Durchmesser mit zunehmendem Abstand von der ersten Hauptfläche abnimmt, aufweisen.

An dem optoelektronischen Bauteil kann eine vom optoelektronischen Bauteil separate Optik befestigt, etwa aufgesteckt oder angeklebt, sein. Diese ist aus Gründen der Übersichtlichkeit nicht gezeigt.

Im Unterschied zum optoelektronischen Bauteil gemäß den Figuren 1 und 2 weist das optoelektronische Bauteil ein thermisches Anschlussteil 215 auf, auf dem der Halbleiterchip 5 angeordnet ist. Das thermische Anschlussteil erstreckt sich in vertikaler Richtung mit Vorzug von der Kavität 240 bis zu einer zweiten Hauptfläche 204 des Gehäusekörpers 20. Das thermische Anschlussteil erleichtert einen, insbesondere gegenüber der Chipmontagefläche auf dem thermischen Anschlussteil, großflächigen, thermischen Anschluss des Halbleiterchips 5 seitens der zweiten Hauptfläche an eine externe Wärmeleitvorrichtung, etwa eine Wärmesenke, z.B. aus Cu. Im Betrieb des Halbleiterchips entstehende Wärme kann so aus dem optoelektronischen Bauteil effizient abgeführt werden, was den Wirkungsgrad und die Lebensdauer des optoelektronischen Bauteils insbesondere beim Betrieb als Hochleistungsbauteil vorteilhaft steigert. Das optoelektronische Bauteil kann zur Erzeugung einer hohen Strahlungsleistung bei einer gleichzeitig aufgrund des thermischen Anschlussteils vorteilhaft verbesserten Wärmeableitung ausgebildet sein. Ein derartiges optoelektronisches Bauteil ist zur Beleuchtung von Flächen, beispielsweise zur Hinterleuchtung einer Anzeigevorrichtung, etwa eines LCDs, besonders geeignet.

Das thermische Anschlussteil 215 ist beispielsweise in eine Lasche eines ersten Anschlussleiters 205 eingelegt, eingesteckt oder anderweitig mit dem ersten Anschlussleiter, insbesondere elektrisch leitend und/oder mechanisch, lateral umfangsseitig verbunden. Weiterhin weist die erste Hauptfläche 202 des Gehäusekörpers 20 eine Ausnehmung 213, welche in der Wand 245 der Kavität gebildet ist, auf. Diese Ausnehmung ist für eine elektrisch leitende Verbindung eines zweiten elektrischen Anschlussleiters 206 mit dem Halbleiterchip 5, beispielsweise mittels des Bonddrahts 290, vorgesehen. Der zweite Anschlussleiter 206 ist vorzugsweise bezüglich der Chipmontage-Ebene des Halbleiterchips 5 auf dem thermischen Anschlussteil 215 erhöht. Das thermische Anschlussteil kann ferner seitens der zweiten Hauptfläche 204 aus dem Gehäusekörper herausragen oder im Wesentlichen eben mit dem Gehäusekörper abschließen. Beispielsweise enthält das thermische Anschlussteil ein Metall hoher Wärmeleitfähigkeit, etwa Cu oder Al, oder eine Legierung, etwa eine CuW-Legierung. Ein Leiterrahmen mit einem derartig ausgebildeten Anschlussteil und einem.Gehäusekörper ist in der WO02/084749. beschrieben. Selbstverständlich kann das im Zusammenhang mit den Figuren 5A und 5B beschriebene optoelektronische Bauteil auch als optoelektronisches Bauteil in den Beleuchtungsanordnungen gemäß den Figuren 1 und 2 eingesetzt werden.

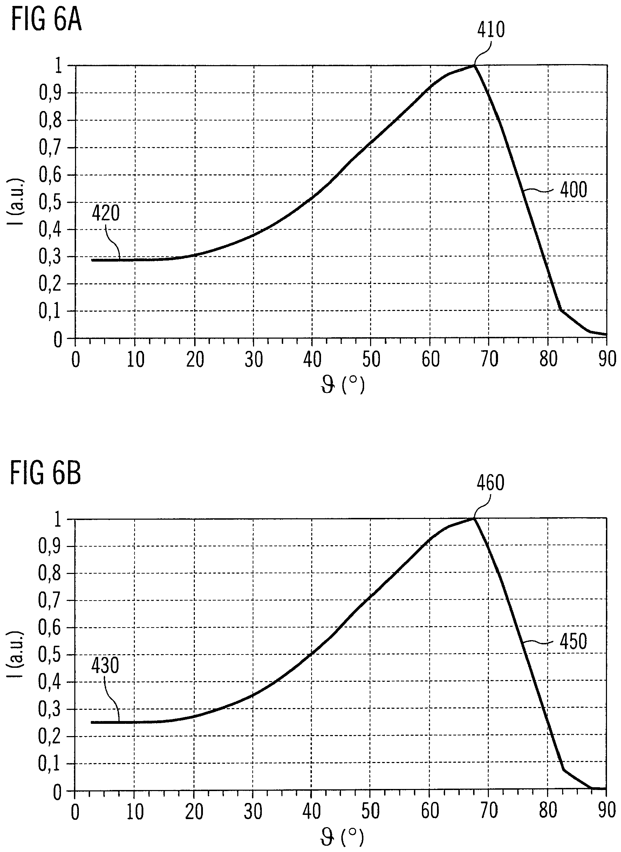

In den Figuren 6A und 6B ist gezeigt, wie sich die Abstrahlcharakteristik einer erfindungsgemäßen Beleuchtungsanordnung gegenüber einer Beleuchtungsanordnung, bei der ein reflektorartig geformtes Element nicht gezielt absorbierend ausgebildet ist, vorteilhaft verändert. Die Abbildung zeigt eine erste Messung (Figur 6A) der im sichtbaren Spektralbereich abgestrahlten Intensität I in beliebigen Einheiten als Funktion des Winkels ϑ zur optischen Achse für eine erste Beleuchtungsanordnung und eine zweite Messung (Figur 6B) der abgestrahlten Intensität I in beliebigen Einheiten als Funktion des Winkels ϑ zur optischen Achse für eine zweite Beleuchtungsanordnung.

Die zweite Beleuchtungsanordnung ist wie im Zusammenhang mit den Figuren 1 und 2 beschrieben ausgeführt. Die erste Beleuchtungsanordnung ist baugleich zur zweiten Beleuchtungsanordnung ausgebildet, wobei das reflektorartig geformte Element jedoch nicht gezielt absorbierend ausgebildet ist.

Der Gehäusekörper 20 der ersten Beleuchtungsanordnung ist aus hochreflektierendem Kunststoff gefertigt, wobei durch Zugabe von TiO₂-Partikeln in die Kunststoffmasse Reflektivitäten von etwa 85% für die Oberfläche des Gehäusekörpers und damit für das reflektorartig geformte Element erreicht werden. Bei der zweiten Beleuchtungsanordnung ist dagegen der Gehäusekörper und somit das reflektorartig geformte Element dadurch gezielt absorbierend ausgebildet, dass die Kunststoffmasse, aus welcher der Gehäusekörper gefertigt ist, durch Zugabe von rußartigen Partikeln schwarz gefärbt ist, so dass die Reflektivität des Gehäusekörpers im sichtbaren Spektralbereich etwa 5% beträgt.

Eine.Kurve 400 zeigt, den Verlauf der Intensität der von der ersten Beleuchtungsanordnung abgestrahlten optischen Leistung in Abhängigkeit vom Winkel zur optischen Achse. Dabei ist die Intensität auf 1 normiert und somit als relative Intensität angegeben.

Entsprechend zeigt eine Kurve 450 die Abstrahlcharakteristik der zweiten Beleuchtungsanordnung, wobei die Intensitätskurve wiederum normiert ist.

Sowohl die Kurve 400 als auch die Kurve 450 weisen bei einem Winkel von etwa 67° zur optischen Achse ein globales Maximum 410 bzw. 460 der Intensität auf. Demnach bewirkt die beschriebene optische Vorrichtung, dass die im optoelektronischen Bauteil erzeugte Strahlung überwiegend nicht entlang der optischen Achse abgestrahlt wird.

Da sich die erste und die zweite Beleuchtungsanordnung im Wesentlichen lediglich durch die Ausführung des reflektorartig geformten Elements unterscheiden, erfährt Strahlung, welche durch die jeweilige Hauptstrahlungsauskoppelfläche 52 austritt und direkt auf die Strahlungsaustrittsfläche trifft, bei beiden Beleuchtungsanordnungen eine im Wesentlichen gleiche Strahlungsformung. Unterschiede zwischen der Abstrahlungscharakteristik der ersten und der zweiten Beleuchtungsanordnung ergeben sich deshalb vorwiegend aufgrund von Strahlung, die den Halbleiterchip jeweils durch eine Seitenfläche 53 verlässt.

Bei der ersten Beleuchtungsanordnung ist das reflektorartig geformte Element 3 aufgrund seiner Formgebung und Anordnung relativ zum Strahlung erzeugenden Halbleiterchip geeignet, zumindest einen Teil der auf das reflektorartig geformte Element treffenden Strahlung auf die Strahlungsaustrittsfläche 41 umzulenken. Wegen der vergleichsweise hohen Reflektivität von etwa 85% kann deshalb ein beträchtlicher Teil der aus den Seitenflächen 53 austretenden Strahlung auf die Strahlungsaustrittsfläche 41 der optischen Vorrichtung 4 umgelenkt werden.

Bei der zweiten Beleuchtungsanordnung ist das reflektorartig geformte Element dagegen für die im Halbleiterchip erzeugte Strahlung gezielt absorbierend ausgebildet, so dass das reflektorartig geformte Element aufgrund der geringen Reflektivität von etwa 5% trotz seiner Form und Anordnung nur einen erheblich geringeren Teil der aus einer der Seitenflächen 53 austretenden Strahlung auf die Strahlungsaustrittsfläche umlenkt.

Im Bereich großer Winkel zur optischen Achse, etwa zwischen 45° und 90°, zeigen die beiden Kurven 400 und 450 einen sehr ähnlichen Verlauf. Von der Beleuchtungsanordnung in diesen Winkelbereich ausgesendete Strahlung ist vorwiegend der Strahlungsanteil, welcher aus der Hauptstrahlungsauskoppelfläche des jeweiligen Halbleiterchips ausgekoppelt wurde.

Für kleinere Winkel zur optischen Achse, von 0° bis etwa 45°, ist die relative Intensität 400 der von der ersten Beleuchtungsanordnung emittierten Strahlung 420, insbesondere im Winkelbereich von 0° bis etwa 30°, signifikant höher als die relative Intensität der von der zweiten Beleuchtungsanordnung in den entsprechenden Bereich 430 emittierte Strahlung. Dies wird, wie im Zusammenhang mit Figur 3 beschrieben, durch Streustrahlung verursacht, die von dem reflektorartig geformten Element auf die Strahlungsaustrittsfläche gelenkt wird und aus dieser vorwiegend in Winkeln zur optischen Achse 40, die erheblich kleiner als 60°, etwa 40° oder kleiner, sind, austritt.

Eine Abstrahlungscharakteristik mit einem Maximum bei Winkeln von 60° oder größer bei gleichzeitiger zusätzlicher Reduktion der in kleine Winkel zur optischen Achse 40 abgestrahlten Strahlungsleistung kann demnach durch die gezielt absorbierende Ausführung des reflektorartig geformten Elements verbessert erzielt werden.

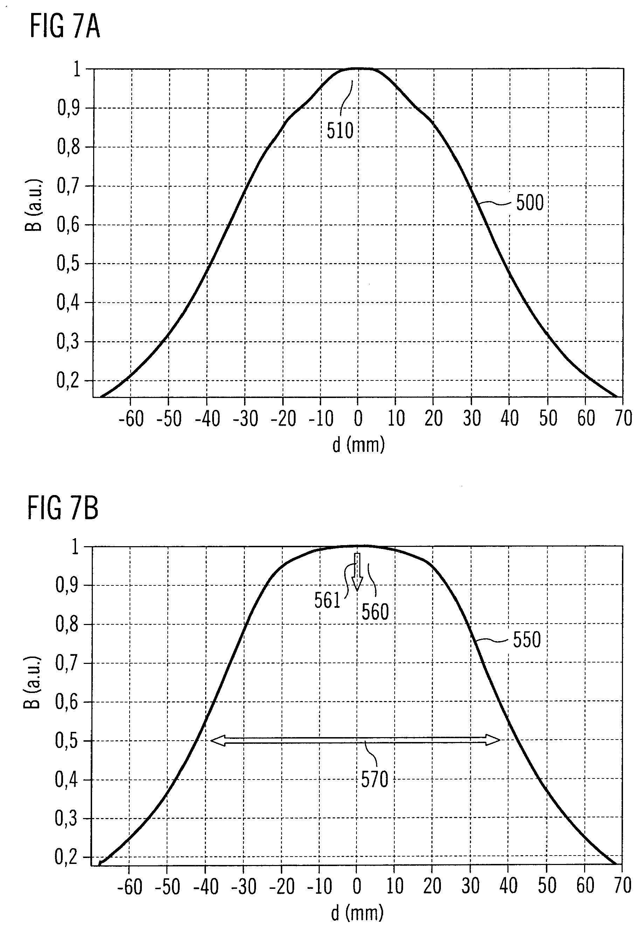

Die Messungen der in den Figuren 7A und 7B gezeigten Beleuchtungsstärkeverteilungen wurden an den selben Bauteilen durchgeführt wie die in Figuren 6A und 6B gezeigten Messungen. Figur 7A und Figur 7B zeigen jeweils die Beleuchtungsstärkeverteilung für die erste bzw. zweite Beleuchtungsanordnung. Sowohl die Kurve 500 für die erste Beleuchtungsanordnung als auch die Kurve 550 für die zweite Beleuchtungsanordnung stellt die Beleuchtungsstärke B entlang einer Gerade dar, welche seitens der Strahlungsaustrittsfläche 41 der optischen Vorrichtung 4 im Abstand von 25 mm über der Oberfläche des Halbleiterchips 5 senkrecht zur optischen Achse 40 verläuft. Auf der x-Achse ist die Entfernung d vom Schnittpunkt dieser Gerade mit der optischen Achse in einer mm-Skala aufgetragen. Die Beleuchtungsstärke ist für die beiden Kurven 500 und 550 auf den jeweiligen Maximalwert, welchen beide Kurven am Schnittpunkt mit der optischen Achse annehmen, normiert und in einer relativen Skala in beliebigen Einheiten angegeben.

Da die Strahlungsaustrittsfläche der optischen Vorrichtung rotationssymmetrisch zur optischen Achse ausgebildet, ist, und die optische Achse im Wesentlichen durch das Zentrum des Halbleiterchips verläuft, sind die beiden Beleuchtungsstärkeverteilungen 500 und 550 im Wesentlichen symmetrisch zur y-Achse.

Im Bereich nahe der y-Achse, etwa für |d|≤10mm, unterscheidet sich der Verlauf 560 der Beleuchtungsstärke bei der zweiten Beleuchtungsanordnung deutlich von dem Verlauf 510 bei der ersten Beleuchtungsanordnung. Während bei der Kurve 500 die Beleuchtungsstärke bei d=10 mm um etwa 5% gegenüber dem Maximalwert abgefallen ist, beträgt der entsprechende Abfall bei der zweiten Kurve lediglich etwa 1%.

Bei der ersten Beleuchtungsanordnung kann aus den Seitenflächen austretende Strahlung vom reflektorartig geformten Element hoher Reflektivität auf die Strahlungsaustrittsfläche 41 umgelenkt werden. Dieser Strahlungsanteil trifft unter einem nur schwer zu kontrollierenden Winkel auf die Strahlungsaustrittsfläche und kann deshalb von der optischen Vorrichtung 4 nur schwer gemäß der der Beleuchtungsanordnung vorgegebenen Abstrahlcharakteristik geformt werden. Die Ablenkung erfolgt überwiegend in vergleichsweise kleine Winkel zur optischen Achse, was zu einer im Bereich 510 überhöhten Beleuchtungsstärke führt. Bei der zweiten Beleuchtungsanordnung dagegen ist das reflektorartig geformte Element gezielt absorbierend ausgebildet, so dass aus der Seitenfläche 53 des Halbleiterchips austretende Strahlung vorwiegend absorbiert wird. Die gesamte der optischen Vorrichtung zur Verfügung gestellte Strahlungsleistung lässt sich dadurch verbessert gemäß einer vorgegebenen Beleuchtungsstärkeverteilung formen.. Wie durch einen Pfeil 561 angedeutet, bewirkt dies im Bereich 560 die gewünschte Reduktion der Beleuchtungsstärke und einen langsameren Abfall der Beleuchtungsstärke mit zunehmendem Abstand zur optischen Achse. Beispielsweise beträgt der Abfall der relativen Beleuchtungsstärke bei d=30mm etwa 0.32 für die Kurve 500, aber nur 0.22 für die Kurve 550.

Eine gebräuchliche Kenngröße für die Breite einer Verteilung ist die volle Halbwertsbreite, welche angibt, wie breit der Bereich um das Maximum der Verteilung ist, im dem der Funktionswert der Verteilung 50% oder mehr des maximalen Funktionswerts beträgt. In Figur 6b ist diese Breite durch einen horizontalen Pfeil 570 angedeutet. Die volle Halbwertsbreite der Kurve 550 ist gegenüber derjenigen der Kurve 500 auf etwa 84mm gegenüber 76mm bei der Kurve 500 vorteilhaft verbreitert.

Die in Figur 7 gezeigten Messungen verdeutlichen, dass die Beleuchtungsstärkeverteilung mittels eines gezielt absorbierend ausgebildeten reflektorartig geformten Elements vorteilhaft signifikant verbreitert werden kann. So kann eine Fläche, die erheblich größer ist als die Oberfläche 52 des Halbleiterchips 5, besonders homogen ausgeleuchtet werden. Damit eignet sich die beschriebene zweite Beleuchtungsanordnung besonders für die Hinterleuchtung von Anzeigevorrichtungen wie LCDs. Aufgrund der großflächigen Ausleuchtung bei kleinen-Abständen der zu beleuchtenden Fläche von der Beleuchtungsanordnung kann die Bautiefe der Hinterleuchtungseinheit vorteilhaft gering gehalten werden.

Zudem kann eine solche Beleuchtungsanordnung beispielsweise für die Allgemeinbeleuchtung, die Effektbeleuchtung, die Ausleuchtung von Leuchtreklamen oder für Leuchtbuchstaben (channel letters) eingesetzt werden.

Die Erfindung ist in Anspruch 1 definiert und nicht durch die Beschreibung anhand der Ausführungsbeispiele beschränkt.

## Patentansprüche

1. Beleuchtungsanordnung (1), umfassend eine optische Vorrichtung (4) mit einer Strahlungsaustrittsfläche (41) und ein optoelektronisches Bauteil (2) zur Erzeugung von Strahlung, wobei
- ein reflektorartig geformtes Element (3) gebildet ist, dessen Formgebung und Anordnung dafür geeignet ist, im Bauteil erzeugte Strahlung durch die Strahlungsaustrittsfläche umzulenken,
- das optoelektronische Bauteil (2) als ein oberflächenmontierbares SMD-Bauteil ausgebildet ist; und
- das reflektorartig geformte Element (3) für im Bauteil erzeugte Strahlung gezielt absorbierend ausgebildet ist; wobei
- das optoelektronische Bauteil (2) das gezielt absorbierend ausgebildete reflektorartig geformte Element enthält; und
- das optoelektronische Bauteil (2) mindestens einen zur Strahlungserzeugung geeigneten Halbleiterchip (5) aufweist;
**dadurch gekennzeichnet, dass** die Reflektivität des reflektorartig geformten Elements (3) für im Bauteil (2) erzeugte Strahlung 15 % oder weniger beträgt; und
der Halbleiterchip als Dünnfilm-Halbleiterchip ausgeführt ist, wobei der Halbleiterkörper auf einem Träger angeordnet ist, der von einem Aufwachssubstrat verschieden ist.

2. Beleuchtungsanordnung nach Anspruch 1, bei der die Strahlungsaustrittsfläche (41) einen konkav gekrümmten Teilbereich (42) und einen den konkav gekrümmten Teilbereich zumindest teilweise umgebenden, konvex gekrümmten Teilbereich (43) aufweist.

3. Beleuchtungsanordnung nach Anspruch 1 oder 2, bei der die optische Vorrichtung (4) an dem optoelektronischen Bauteil (2) befestigt ist.

4. Beleuchtungsanordnung nach einem der vorherigen Ansprüche, bei der ein minimaler Abstand zwischen der Strahlungsaustrittsfläche (41) und dem Halbleiterchip (5) kleiner oder gleich 5mm ist.

5. Beleuchtungsanordnung nach einem der vorherigen Ansprüche, bei der ein minimaler Abstand zwischen der Strahlungsaustrittsfläche (41) und dem Halbleiterchip (5) kleiner oder gleich 3mm ist.

6. Beleuchtungsanordnung nach einem der vorherigen Ansprüche, bei der die optische Vorrichtung (4) zur Formung einer der Beleuchtungsanordnung vorgegebenen Abstrahlcharakteristik ausgebildet ist, wobei ein Auftreffen von aus dem Halbleiterchip (5) ausgekoppelter Strahlung nach einer Reflexion innerhalb der Beleuchtungsanordnung auf die Strahlungsaustrittsfläche (41) zumindest teilweise unterdrückt wird.

7. Beleuchtungsanordnung nach einem der vorherigen Ansprüche, wobei der Halbleiterchip (5) eine als Hauptstrahlungsauskoppelfläche ausgeführte Oberfläche (52) und eine eine Nebenstrahlungsaustrittsfläche bildende Seitenfläche (53) aufweist, wobei die Formgebung und Anordnung des reflektorartig geformten Elements (3) dafür geeignet ist, zumindest einen Teil der aus der Nebenstrahlungsaustrittsfläche austretenden Strahlung umzulenken.

8. Beleuchtungsanordnung nach einem der vorherigen Ansprüche, bei der der Halbleiterchip (5) einen Halbleiterkörper (54), welcher eine Halbleiterschichtenfolge mit einem für die Erzeugung von Strahlung vorgesehenen aktiven Bereich (51) aufweist, und einen Träger (55) umfasst, wobei der Halbleiterkörper auf dem Träger angeordnet ist und der Träger von einem Aufwachssubstrat der Halbleiterschichtenfolge verschieden ist.

9. Beleuchtungsanordnung nach Anspruch 8,
bei der zwischen dem Halbleiterkörper (54) und dem Träger (55) eine Spiegelschicht (56) angeordnet ist, wobei die Spiegelschicht (56) ein Metall enthält oder metallisch ist.

10. Beleuchtungsanordnung nach einem der Ansprüche 1 bis 9,
bei der das optoelektronische Bauteil einen Gehäusekörper (20) und einen externen elektrischen Anschlussleiter (205) umfasst, wobei der Gehäusekörper das reflektorartig geformte Element (3) enthält und der Halbleiterchip (5) auf dem Anschlussleiter befestigt ist.

11. Beleuchtungsanordnung nach Anspruch 10,
bei der das reflektorartig geformte Element (3) mittels einer Wand (245) einer Kavität (240) des Gehäusekörpers (20) gebildet ist, wobei der Halbleiterchip (5) in der Kavität (240) des Gehäusekörpers (20) angeordnet ist.

12. Beleuchtungsanordnung nach Anspruch 10 oder 11,
bei der der Gehäusekörper (20) aus einer schwarzen Keramik gefertigt ist oder bei der Gehäusekörper eine Keramik enthält und geschwärzt ist.

13. Beleuchtungsanordnung nach Anspruch 10 oder 11,
bei der der Gehäusekörper (20) aus schwarzem Kunststoff gefertigt ist oder bei der der Gehäusekörper einen Kunststoff enthält und geschwärzt ist.

14. Beleuchtungsanordnung nach einem der Ansprüche 1 bis 13,
bei der das reflektorartig geformte Element (3) zumindest teilweise aus schwarzem Material oder einer schwarzen Materialzusammensetzung gefertigt oder zumindest teilweise mit einem schwarzen Material oder einer schwarzen Materialzusammensetzung versehen ist.

15. Beleuchtungsanordnung nach einem der vorhergehenden Ansprüche,
wobei die Beleuchtungsanordnung zur Hinterleuchtung einer Anzeigevorrichtung, etwa eines LCDs, vorgesehen ist.

## Claims

1. Lighting arrangement (1), comprising an optical apparatus (4) with a radiation outlet surface (41) and an optoelectronic component (2) for producing radiation, wherein
- an element (3) which is formed like a reflector being formed, whose shape and arrangement are suitable for deflecting radiation generated in the component through the radiation outlet surface,
- the optoelectronic component (2) is formed as a surface-mountable SMD-component, and
- the element (3) which is formed like a reflector being designed to specifically absorb radiation which is generated in the component, wherein
- the optoelectronic component (2) comprises the element which is formed like a reflector and which is designed specifically absorbent, and
- the optoelectronic component (2) comprises at least one semiconductor chip (5) which is suitable for radiation production,
**characterised in that**
the reflectivity of the element (3) which is formed like a reflector is less than or equal to 15%, and
the semiconductor chip is formed as a thin-film semiconductor chip, with the semiconductor body being arranged on a carrier and with the carrier being different from a growth substrate.

2. Lighting arrangement according to claim 1, in which the radiation outlet surface (41) has a concave-curved subarea (42) and a convex-curved subarea (43) which at least partially surrounds the concave-curved subarea.

3. Lighting arrangement according to claim 1 or 2, in which the optical apparatus (4) is attached to the optoelectronic component (2).

4. Lighting arrangement according to one of the preceding claims, in which a minimum distance between the radiation outlet surface (41) and the semiconductor chip (5) is less than or equal to 5 mm.

5. Lighting arrangement according to one of the preceding claims, in which a minimum distance between the radiation outlet surface (41) and the semiconductor chip (5) is less than or equal to 3 mm.

6. Lighting arrangement according to one of the preceding claims, in which the optical apparatus (4) is designed to form an emission characteristic which is predetermined for the lighting arrangement, with radiation which is output from the semiconductor chip (5) being at least partially prevented from striking the radiation outlet surface (41) after reflection within the lighting arrangement.

7. Lighting arrangement according to one of the preceding claims, in which a surface of the semiconductor chip (5) forms a main radiation output surface (52), and a side surface forms a secondary radiation outlet surface (53), wherein the shape and arrangement of the element (3) which is formed like a reflector are suitable for deflecting at least a part of the radiation which emerges from the secondary radiation outlet surface.

8. Lighting arrangement according to one of the preceding claims, in which the semiconductor chip (5) comprises a semiconductor body (54), which comprises a semiconductor layer sequence with an active area (51) which is intended to generate radiation, and a carrier (55), with the semiconductor body being arranged on the carrier and with the carrier being different from a growth substrate of the semiconductor layer sequence.

9. Lighting arrangement according to claim 8, in which a mirror layer (56) is arranged between the semiconductor body (54) and the carrier (55), where the mirror layer (56) comprises a metal or is metallic.

10. Lighting arrangement according to one of the claims 1 to 9, in which the optoelectronic component comprises a housing body (20) and an external electrical connecting conductor (205), with the housing body containing the element (3) which is formed like a reflector, and with the semiconductor chip (5) being mounted on the connecting conductor.

11. Lighting arrangement according to claim 10, in which the element (3) which is formed like a reflector is formed by means of a wall (245) of a cavity (240) in the housing body (20), where the semiconductor chip (5) is arranged in the cavity (240) of the housing body (20).

12. Lighting arrangement according to claim 10 or 11, in which the housing body (20) is manufactured from a black ceramic, or the housing body comprises a ceramic and is blackened.

13. Lighting arrangement according to claim 10 or 11, in which the housing body (20) is manufactured from a black plastic, or the housing body comprises a plastic and is blackened.

14. Lighting arrangement according to one of the claims 1 to 13, in which the element (3) which is formed like a reflector is manufactured at least partly from black material or from a black material composition, or is provided at least partly with a black material or a black material composition.

15. Lighting arrangement according to one of the preceding claims, wherein the lighting arrangement is intended for backlighting of a display apparatus, for example an LCD.

## Revendications

1. Dispositif d'éclairage (1) comprenant un dispositif optique (4) présentant une surface de sortie de rayonnement (41) et un composant optoélectronique (2) pour générer un rayonnement, dans lequel
- un élément (3) est conçu en forme de réflecteur, dont la forme et l'agencement sont appropriés pour dévier le rayonnement généré dans le composant à travers la surface de sortie du rayonnement,
- le composant optoélectronique (2) est conçu sous la forme d'un composant CMS montable en surface ; et
- l'élément en forme de réflecteur (3) est spécifiquement conçu pour absorber le rayonnement généré dans le composant ; sur lequel
- le composant optoélectronique (2) contient l'élément conçu en forme de réflecteur et spécifiquement absorbant ; et
- le composant optoélectronique (2) comprend au moins une puce semi-conductrice (5) appropriée pour générer un rayonnement ;
**caractérisé en ce que**
la réflectivité de l'élément en forme de réflecteur (3) pour le rayonnement généré dans le composant (2) est de 15 % ou moins ; et
la puce semi-conductrice est formée sous la forme d'une puce semi-conductrice à couche mince, dans laquelle le corps semiconducteur est disposé sur un support différent d'un substrat de croissance.

2. Dispositif d'éclairage selon la revendication 1, sur lequel la surface de sortie de rayonnement (41) présente une partie incurvée concave (42) et une partie incurvée convexe (43) entourant au moins partiellement la partie incurvée concave.

3. Dispositif d'éclairage selon la revendication 1 ou 2, dans lequel
le dispositif optique (4) est fixé au composant optoélectronique (2).

4. Dispositif d'éclairage selon l'une des revendications précédentes, sur lequel une distance minimale entre la surface de sortie de rayonnement (41) et la puce semi-conductrice (5) est inférieure ou égale à 5 mm.

5. Dispositif d'éclairage selon l'une des revendications précédentes, sur lequel une distance minimale entre la surface de sortie de rayonnement (41) et la puce semi-conductrice (5) est inférieure ou égale à 3mm.

6. Dispositif d'éclairage selon l'une des revendications précédentes, sur lequel le dispositif optique (4) est conçu pour former une caractéristique de rayonnement prédéfinie du dispositif d'éclairage, dans lequel un impact du rayonnement découplé hors de la puce semi-conductrice (5) après réflexion à l'intérieur du dispositif d'éclairage sur la surface de sortie de rayonnement (41) est au moins partiellement réprimé.

7. Dispositif d'éclairage selon l'une des revendications précédentes,
la puce semi-conductrice (5) présentant une surface (52) conçue en tant que surface de découplage du rayonnement principal et une surface latérale (53) formant une surface de sortie de rayonnement secondaire, la forme et l'agencement de l'élément en forme de réflecteur (3) permettant de dévier au moins une partie du rayonnement sortant de la surface de sortie de rayonnement secondaire.

8. Dispositif d'éclairage selon l'une des revendications précédentes,
sur lequel la puce semi-conductrice (5) comprend un corps semi-conducteur (54) doté d'une succession de couches semi-conductrices présentant une zone active (51) prévue pour générer un rayonnement et un support (55),
le corps semi-conducteur étant disposé sur le support et le support étant différent d'un substrat de croissance de la succession de couches semi-conductrices.

9. Dispositif d'éclairage selon la revendication 8,
sur lequel une couche miroir (56) est disposée entre le corps semi-conducteur (54) et le support (55), la couche miroir (56) contenant un métal ou étant métallique.

10. Dispositif d'éclairage selon l'une des revendications 1 à 9,
sur lequel le composant optoélectronique comprend un corps de boîtier (20) et un conducteur de connexion électrique externe (205), le boîtier contenant l'élément en forme de réflecteur (3) et la puce semi-conductrice (5) étant fixée au conducteur de connexion.

11. Dispositif d'éclairage selon la revendication 10,
sur lequel l'élément en forme de réflecteur (3) est conçu au moyen d'une paroi (245) d'une cavité (240) du corps de boîtier (20), la puce semi-conductrice (5) étant disposée dans la cavité (240) du corps de boîtier (20).

12. Dispositif d'éclairage selon la revendication 10 ou 11,
sur lequel le corps du boîtier (20) est en céramique noire ou sur lequel le corps du boîtier contient une céramique et est noirci.

13. Dispositif d'éclairage selon la revendication 10 ou 11,
sur lequel le corps du boîtier (20) est en plastique noir ou sur lequel le corps du boîtier contient une matière plastique et est noirci.

14. Dispositif d'éclairage selon l'une des revendications 1 à 13,
sur lequel l'élément en forme de réflecteur (3) est au moins partiellement constitué d'un matériau noir ou d'un composé de matériaux noirs ou au moins partiellement pourvu d'un matériau noir ou d'un composé de matériaux noirs.

15. Dispositif d'éclairage selon l'une des revendications précédentes,
sur lequel le dispositif d'éclairage est prévu pour le rétroéclairage d'un dispositif d'affichage, tel qu'un écran LCD.
